# EUROPEAN PATENT APPLICATION

(11) **EP 1 688 792 A1**
(43) Date of publication of application: **09.08.2006**
(21) Application number: 06100889.2
(22) Date of filing: 26.01.2006
(51) Int. Cl.: G03F 7/031, G03F 7/029

(54) **Light sensitive planographic printing plate material and planographic printing plate manufacturing method therefrom**

(30) Priority: 03.02.2005 JP 2005027442
(71) Applicant: Konica Minolta Medical & Graphic, Inc., Tokyo 163-0512 (JP)
(72) Inventor: Matsumura, Toshiyuki, 192-8505, Tokyo (JP)
(74) Representative: Henkel, Feiler & Hänzel

(57) **Abstract**

Disclosed is a light sensitive planographic printing plate material comprising a support and provided thereon, a light sensitive layer containing a spectral sensitizing agent, a photopolymerization initiator, a polymerizable compound, and a polymer binder, the light sensitive layer having a coating amount of from 0.1 to 10 g/m², wherein the spectral sensitizing agent is a compound represented by formula (1),

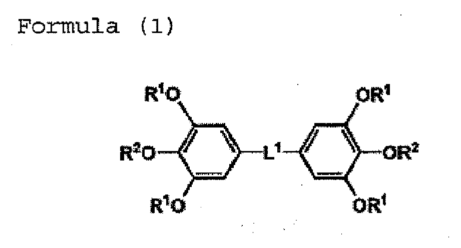

## Description

This application is based on Japanese Patent Application No. 2005-027442, filed on February 3, 2005 in Japanese Patent Office, the entire content of which is hereby incorporated by reference.

### FIELD OF THE INVENTION

The present invention relates to a light sensitive planographic printing plate material used in a computer-to-plate (hereinafter referred to as CTP) system, and particularly to a light sensitive planographic printing plate material suitable for exposure employing laser light having a wavelength of 350 to 450 nm and a process of manufacturing a printing plate from the light sensitive planographic printing plate material.

### BACKGROUND OF THE INVENTION

In recent years, a CTP system has been developed and put into practical use, which directly writes digital image data on a light sensitive planographic printing plate material employing laser light in a process of manufacturing a printing plate for off-set printing.

In a printing field in which relatively high printing durability is required, a negative working light sensitive planographic printing plate material is known which comprises a polymerizable light sensitive layer containing a polymerizable compound (see for example, Japanese Patent O.P.I. Publication Nos. 1-105238 and 2-127404).

As a light source used for exposure of the polymerizable light sensitive layer, light sources such as an Ar laser (488 nm) and a YD-YAG laser (532 nm) are known, however, use of these light sources, which do not have so high output power, is not satisfactory in production efficiency and in workability under a safelight.

Recently, a high output power compact laser continuously emitting rays with a short wavelength (350 to 450 nm) can be easily obtained. In order to improve productivity or safelight property described above, a printing plate material adapted to laser with the short wavelength as described above has been sought.

As such a printing plate material are known a printing plate material comprising a light sensitive layer adapted to laser with a wavelength of from 350 to 450 nm containing a specific carbonyl compound and a titanocene compound (see Japanese Patent O.P.I. Publication No. 2000-98605), a printing plate material comprising a light sensitive layer adapted to laser with a wavelength of from 450 to 550 nm containing a specific spectral sensitizing agent and a radical generating agent (see Japanese Patent O.P.I. Publication Nos. 2003-206307), and a printing plate material comprising a light sensitive layer adapted to laser with a wavelength of from 350 to 450 nm containing a specific styryl compound and a specific fluorescent brightening agent (see Japanese Patent O.P.I. Publication Nos. 2003-221517 and 2003-295426).

However, these printing plate materials have still problems in that sensitivity, storage stability and developing property are insufficient.

### SUMMARY OF THE INVENTION

An object of the invention is to provide a light sensitive planographic printing plate material adapted to a laser emitting light with an emission wavelength of from 350 to 450 nm, which provides high sensitivity, excellent storage stability and excellent developing property, and to provide a process of manufacturing a planographic printing plate employing the light sensitive planographic printing plate material.

### DETAILED DESCRIPTION OF THE INVENTION

The above object has been attained by one of the following constitutions:
1. A light sensitive planographic printing plate material comprising a support and provided thereon, a light sensitive layer containing a spectral sensitizing agent, a photopolymerization initiator, a polymerizable compound, and a polymer binder, the light sensitive layer having a coating amount of from 0.1 to 10 g/m², wherein the spectral sensitizing agent is a compound represented by formula (1), 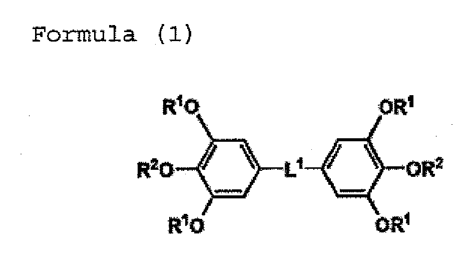 wherein R¹ represents a hydrogen atom, an alkyl group having a carbon atom number of from 1 to 6 or an aryl group; R² represents an alkyl group having a carbon atom number of from 2 to 30, an alkenyl group or an aryl group, R² being different from R¹; and L¹ represents a divalent linkage group selected from the group A consisting of linkage groups represented by the following formulae (a), (b), (c), (d), (e), (f), (g), (h), (i), (j), (k), (l), (m) and (n), 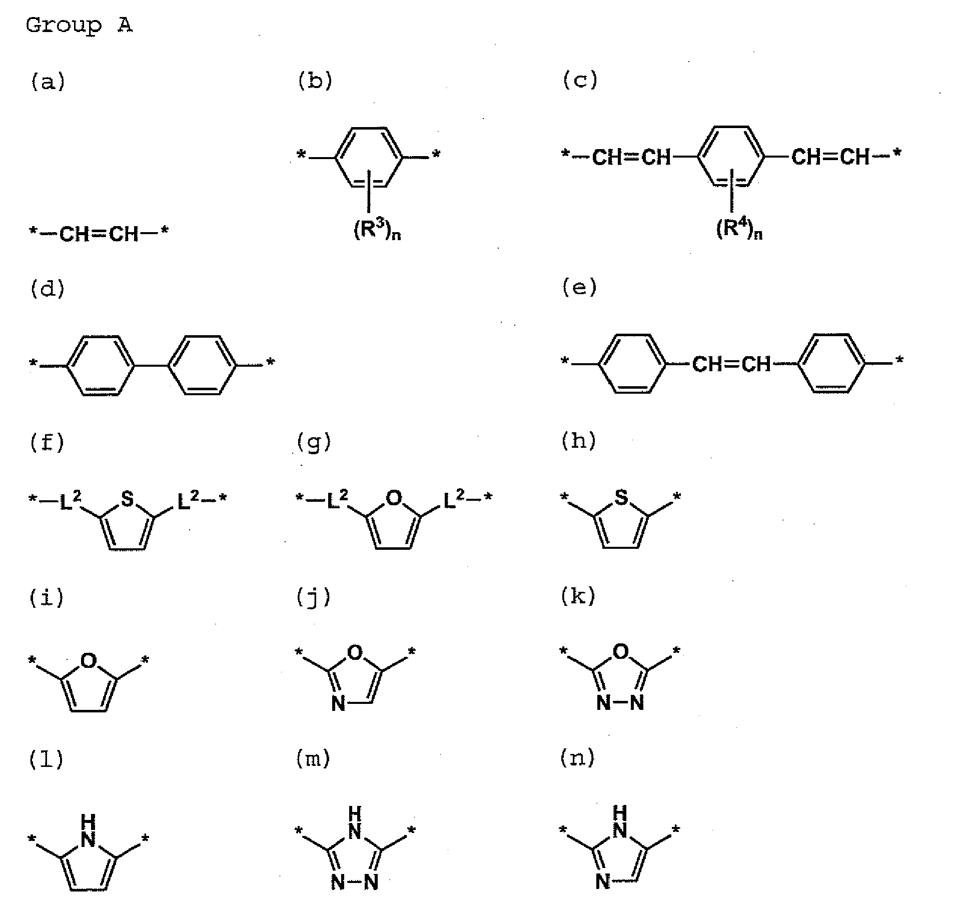 wherein R³ and R⁴ independently represent an alkyl group, an alkoxy group or a halogen atom; n represents an integer of from 0 to 4; the asterisk * represents a linkage position; and L² represents a divalent linkage group selected from the group B consisting of linkage groups represented by the following formulae (o), (p), (q), (r), (s), (t), (u), (v), and (w), 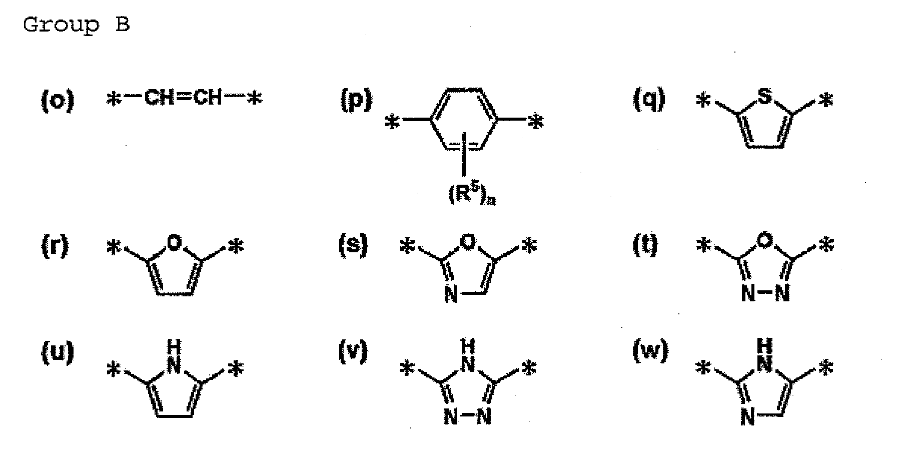 wherein R⁵ represents an alkyl group, an alkoxy group or a halogen atom; n represents an integer of from 0 to 4; and the asterisk "*" represents a linkage position.
2. The light sensitive planographic printing plate material of item 1 above, wherein in formula (1), R² represents an alkyl group having a carbon atom number of from 2 to 6.
3. The light sensitive planographic printing plate material of item 1 or 2 above, wherein in formula (1), R² represents an alkyl group having a carbon atom number of from 2 to 6; and L¹ represents a divalent linkage group represented by formula (c).
4. The light sensitive planographic printing plate material of any one of items 1 through 3 above, wherein the polymerization initiator is a hexaarylbisimidazole compound.
5. The light sensitive planographic printing plate material of any one of items 1 through 4 above, wherein the polymerizable compound is a compound having an ethylenically double bond.
6. The light sensitive planographic printing plate material of item 1 above, wherein the light sensitive layer contains a mercapto compound.
7. The light sensitive planographic printing plate material of item 1 above, wherein the light sensitive layer contains a polymerization inhibitor.
8. The light sensitive planographic printing plate material of item 7 above, wherein the light sensitive layer contains the spectral sensitizing agent in an amount of from 0.1 to 20% by weight, the polymerization initiator in an amount of from 0.1 to 20% by weight, the polymerizable compound in an amount of from 10 to 70% by weight, the polymer binder in an amount of from 10 to 90% by weight, and the polymerization inhibitor in an amount of from 0.01 to 5% by weight.
9. The light sensitive planographic printing plate material of any one of items 1 through 8 above, wherein a protective layer containing polyvinyl alcohol or polyvinyl pyrrolidone is provided on the light sensitive layer.
10. The light sensitive planographic printing plate material of any one of items 1 through 9 above, wherein the light sensitive layer has a coating amount of from 0.5 to 5 g/m².
11. A process of manufacturing a printing plate, the process comprising the steps of imagewise exposing to laser light the light sensitive planographic printing plate material of any one of items 1 through 10 above, and developing the exposed printing material with an alkaline developer.

The present invention is a light sensitive planographic printing plate material comprising a support and provided thereon, a light sensitive layer containing a spectral sensitizing agent, a photopolymerization initiator, a polymerizable compound, and a polymer binder, wherein the spectral sensitizing agent is a compound represented by formula (1) above.

The present invention can provide a light sensitive planographic printing plate material providing high sensitivity, excellent storage stability, and excellent developing property and a process of manufacturing a printing plate from the light sensitive planographic printing plate material, the light sensitive planographic printing plate material comprising a light sensitive layer containing as a spectral sensitizing agent a compound represented by formula
(1) above.

The present invention will be detailed below.

### (Spectral sensitizing agent)

The spectral sensitizing agent in the invention increases sensitivity of a polymerization initiator to light for imagewise exposure. In the invention, the light sensitive layer of the light sensitive planographic printing plate material of the invention contains, as a spectral sensitizing agent, a compound represented by formula (1) above.

In formula (1), R¹ represents a hydrogen atom, an alkyl group having a carbon atom number of from 1 to 6 or an aryl group, provided that the alkyl group or aryl group may have a substituent; R² represents an alkyl group having a carbon atom number of from 2 to 30, an alkenyl group or an aryl group, R² being different from R¹, provided that the alkyl group, alkenyl group or aryl group may have a substituent; and L¹ represents a divalent linkage group selected from the group A above, wherein R³ and R⁴ independently represent an alkyl group (preferably an alkyl group having a carbon atom number of from 1 to 6), an alkoxy group or a halogen atom, provided that the alkyl group or alkoxy group may have a substituent, n represents an integer of from 0 to 4, the asterisk "*" represents a linkage position, and L² represents a divalent linkage group selected from the group B above, in which R⁵ represents an alkyl group, an alkoxy group or a halogen atom, n represents an integer of from 0 to 4, and the asterisk "*" represents a linkage position.

The alkyl group of R¹ is preferably a methyl group, an ethyl group or a propyl group, and more preferably a methyl group or an ethyl group. The aryl group of R¹ is preferably a phenyl group or a naphthyl group.

The alkyl group of R² is preferably an ethyl group, a propyl group, an isopropyl group or a butyl group. The alkenyl group of R² is preferably a vinyl group or an allyl group. The aryl group of R² is preferably a phenyl group or a naphthyl group.

The alkyl group of R³, R⁴ and R⁵ is preferably a methyl group, an ethyl group or a propyl group. The alkoxy group of R³, R⁴ and R⁵ is preferably a methoxy group or an ethoxy group.

L¹ represents a divalent linkage group represented by one of the formulae (a) through (n) above. Preferred L¹ is a divalent linkage group represented by formula (c).

L² represents a divalent linkage group represented by one of the formulae (o) through (w) above. Preferred L² is a divalent linkage group represented by formula (o), (p) or (r) .

As the spectral sensitizing agent in the invention, a compound is preferred which absorbs light having a wavelength which a light source used for imagewise exposure emits. Typically, a compound having absorption maximum in the wavelength regions of from 350 to 450 nm is preferred, and a compound having absorption maximum in the wavelength regions of from 350 to 410 nm is more preferred.

Examples of the spectral sensitizing agent in the invention will be listed below, but the invention is not specifically limited thereto.

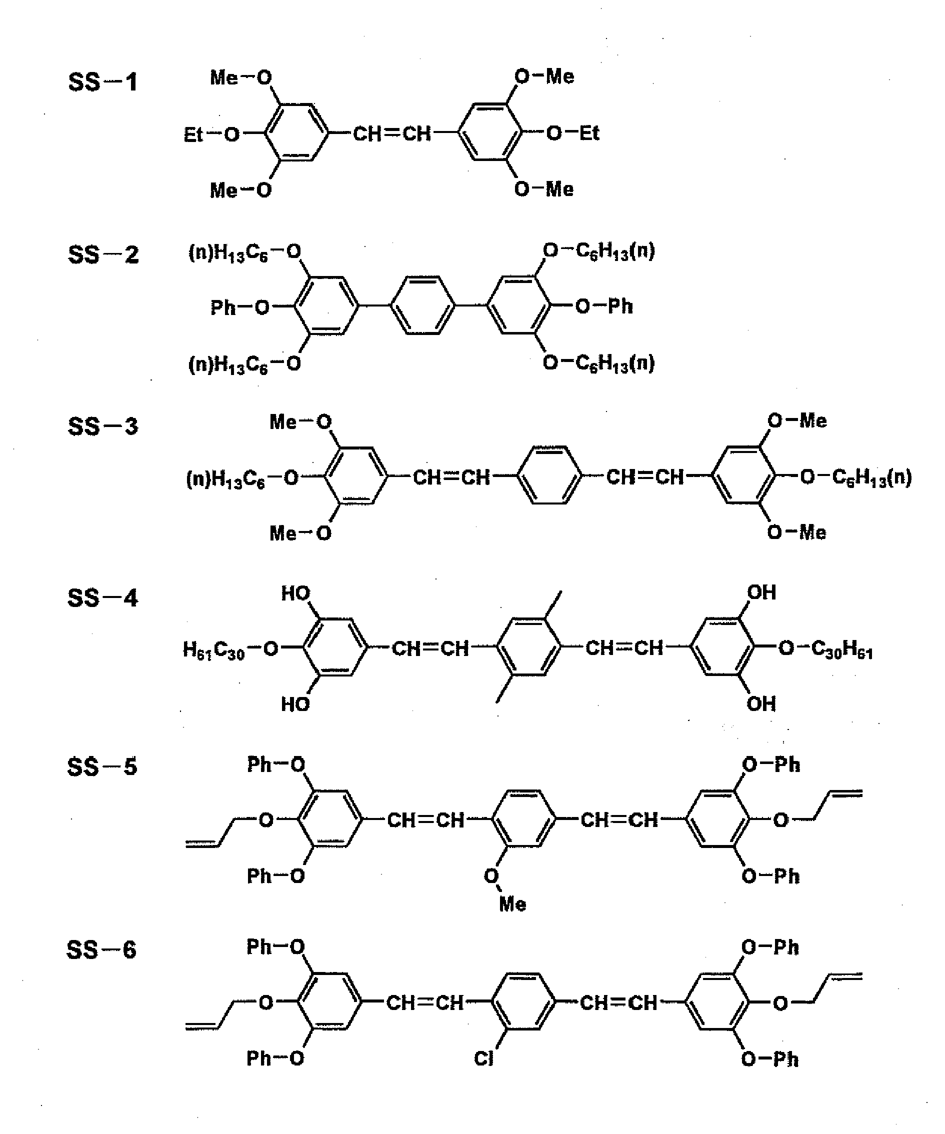

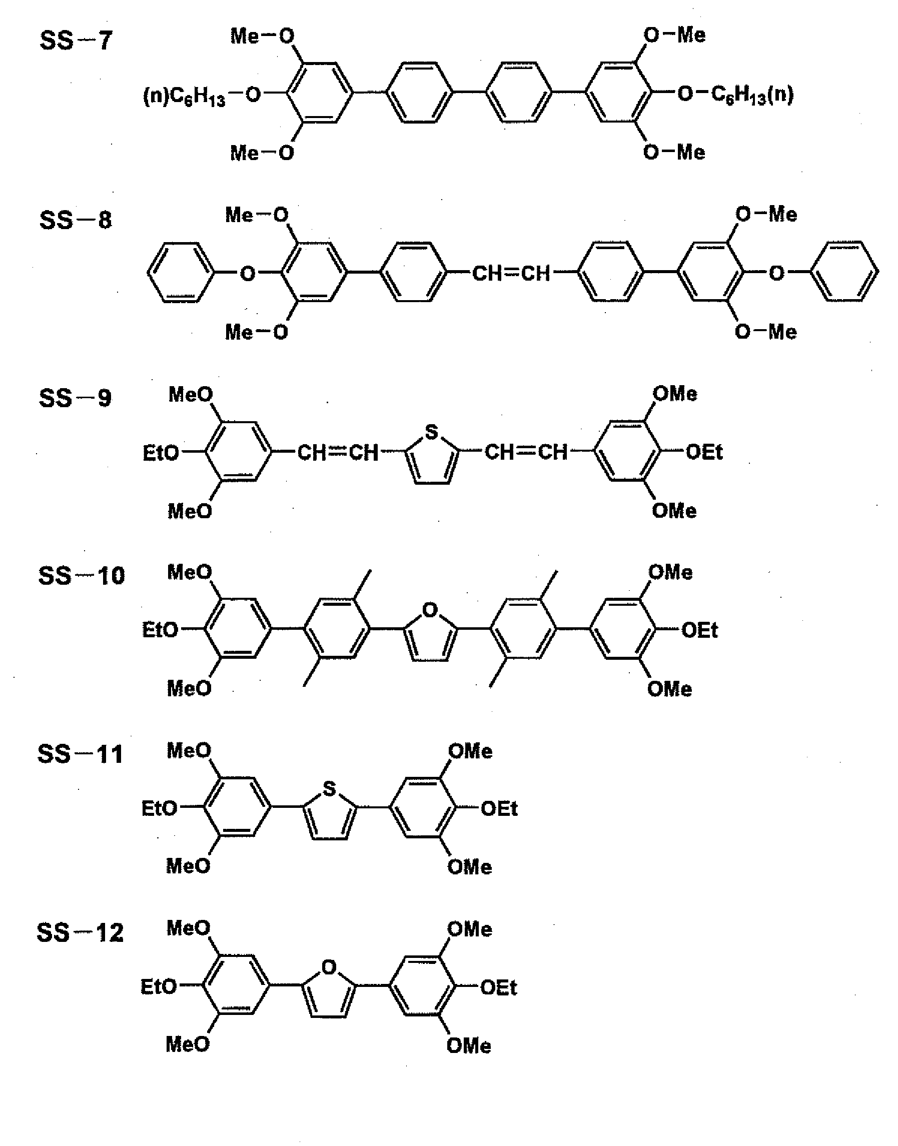

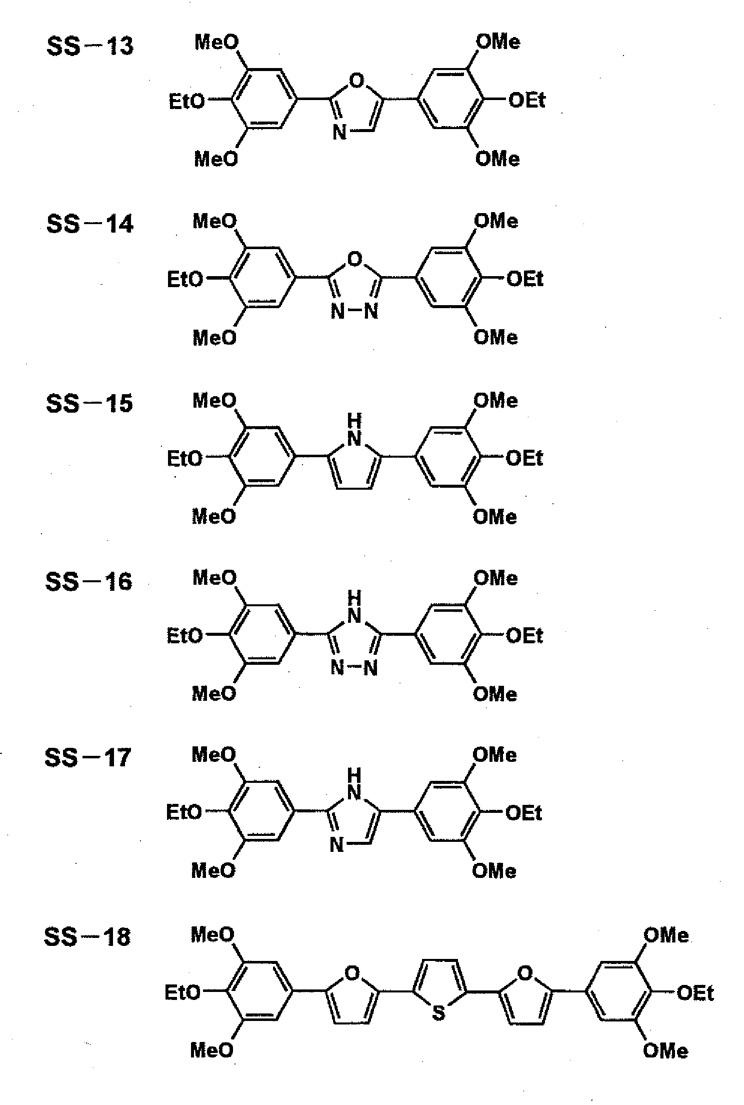

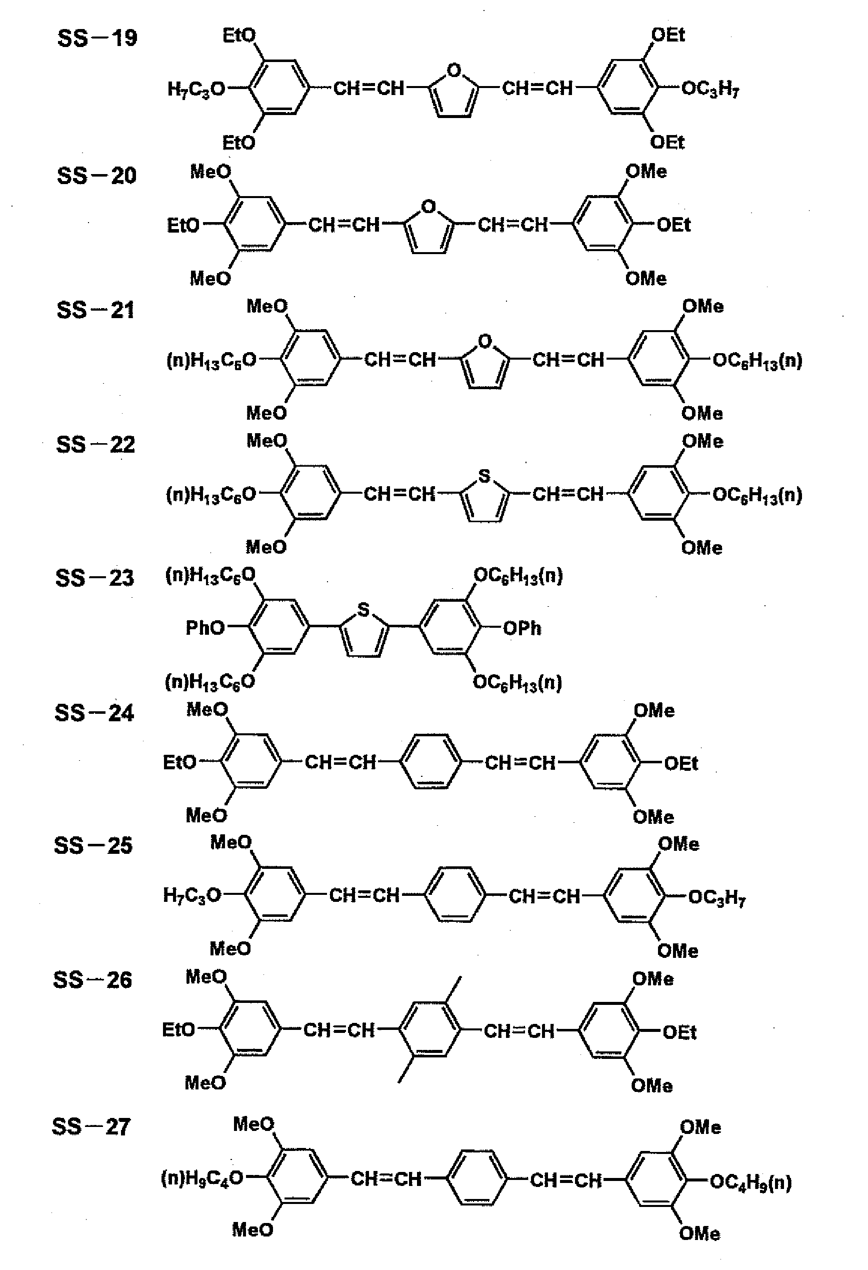

In the invention, a spectral sensitizing dye having a chemical structure different from formula (1) can be used in combination. Examples of such a spectral sensitizing agent include optical brightening agents described in JP-A No. 2003-295426, spectral sensitizing agents of JP-A No. 2003-21901, compounds having the structures represented by General Formula (I) of JP-A No. 2003-21895, compounds having the structures represented by General Formula (I) of JP-A No. 21894, spectral sensitizing agents having the specified structures of JA-A No. 2002-351072, spectral sensitizing agents having the specified structures of JP-A No. 2002-351071, spectral sensitizing agents having specified structures (being a pyrrolopyrrole ring) of JP-A No. 2002-351065, spectral sensitizing agents of JP-A No. 2002-268239, spectral sensitizing agents of JP-A No. 2002-268238, spectral sensitizing agents of JP-A No. 2002-268204, compounds having the structures represented by General Formula (I) of JP-A No. 2002-221790, compounds having structures represented by General Formula (I) of JP-A No. 2002-202598, carbazole type spectral sensitizing agents of JP-A No. 2001-042524, spectral sensitizing agents of JP-A No. 2000-309724, spectral sensitizing agents of JP-A No. 2000-258910, naphtho[1,8-bc]furan-5-one derivatives of JP-A No. 2000-206690, merocyanine agents of JP-A No. 2000-147763, and carbonyl compounds of JP-A No. 2000-098605.

In addition to the above spectral sensitizing agents, spectral sensitizing agents, which can be used in combination, include cyanine, merocyanine, porphyrin, a spiro compound, ferrocene, fluorene, fulgide, imidazole, perylene, phenazine, phenothiazine, acridine, an azo compound, diphenylmethane, triphenylmethane, triphenylamine, cumarin derivatives, ketocumarin, quinacridone, indigo, styryl, pyrylium compounds, pyrromethene compounds, pyrazolotriazole compounds, benzothiazole compounds, barbituric acid derivatives, thiobarbituric acid derivatives, and ketoalcohol borate complexes.

The content of spectral sensitizing agent in the invention in the light-sensitive layer is optional, but is preferably from 0.1 to 20% by weight, and more preferably from 0.8 to 15% by weight. In more detail, when the spectral sensitizing agent in the invention is applied to a light sensitive layer of light sensitive planographic printing plate material, the content of the spectral sensitizing agent in the light sensitive layer added is preferable an amount which provides an absorbance of reflection spectra of preferably from 0.2 to 2.0, and more preferably from 0.3 to 1.3, the absorbance being measured at a wavelength of a laser used, employing an integrating sphere.

These spectral sensitizing dyes can be used solely or in combination thereof.

### (Polymerization initiator)

The polymerization initiator is a compound capable of initiating polymerization of a polymerizable compound upon imagewise exposure. In the invention, various conventional polymerization initiators can be used.

Examples of the polymerization initiator include radical generating compounds disclosed in Japanese Patent Publication No. 2002-537419, polymerization initiators disclosed in Japanese Patent O.P.I. Publication Nos. 2001-175006, 2002-278057, and 2003-5363, onium salts having two or more cation portions in the molecule disclosed in Japanese Patent O.P.I. Publication No. 2003-76010, N-nitroso amine compounds disclosed in Japanese Patent O.P.I. Publication No. 2001-133966, thermally radical generating compounds disclosed in Japanese Patent O.P.I. Publication No. 2001-343742, compounds of generating a radical or an acid by heat disclosed in Japanese Patent O.P.I. Publication No. 2002-6482, borate compounds disclosed in Japanese Patent O.P.I. Publication No. 2002-116539, compounds of generating a radical or an acid by heat disclosed in Japanese Patent O.P.I. Publication No. 2002-148790, photopolymerization initiators or thermal polymerization initiators each having a polymerizable unsaturated group disclosed in Japanese Patent O.P.I. Publication No. 2002-207293, onium salts having, as a counter ion, a divalent or more valent anion disclosed in Japanese Patent O.P.I. Publication No. 2002-268217, sulfonylsulfone compounds having a specific structure disclosed in Japanese Patent O.P.I. Publication No. 2002-328465, thermally radical generating compounds disclosed in Japanese Patent O.P.I. Publication No. 2002-341519, iron-arene complexes disclosed in Japanese Patent O.P.I. Publication No. 59-219307, and hexaarylbisimidazoles disclosed in Japanese Patent O.P.I. Publication No. 2003-295426.

Preferred polymerization initiators are triarylsulfonium compounds, diaryliodonium compounds, trihalomethyltriazine compounds, acylphosphinoxides, benzoin derivatives, N-phenylglycine derivatives, titanocene compounds, hexaarylbisimidazole compounds, and iron-arene compounds.

Examples of the titanocene compound include dicyclopentadienyl-Ti-dichloride, dicyclopentadienyl-Ti-bisphenyl, dicyclopentadienyl-Ti-bis-2,3,4,5,6-pentafluorophenyl, dicyclopentadienyl-Ti-bis-2,3,5,6-tetrafluorophenyl, dicyclopentadienyl-Ti-bis-2,4,6-trifluorophenyl, dicyclopentadienyl-Ti-bis-2,6-difluorophenyl, dicyclopentadienyl-Ti-bis-2,4-difluorophenyl, dimethylcyclopentadienyl-Ti-bis-2,3,4,5,6-pentafluorophenyl, dimethylcyclopentadienyl-Ti-bis-2,3,5,6-tetrafluorophenyl, dimethylcyclopentadicnyl-Ti-bis-2,4-difluorophenyl, bis(cyclopentadienyl)-bis{2,6-difluoro-3-(pyrr-1-yl)phenyl}titanium (IRUGACURE 784, produced by Ciba Specialty Co., Ztd.).

In the invention, especially preferred polymerization initiators are hexaarylbisimidazoles and their derivatives. The synthetic method of the hexaarylbisimidazoles (HABI, dimmers of triarylimidazoles) is disclosed in DIELECTRIC 1470154, and use thereof in a photopolymerizable composition is disclosed in EP 24629, EP 107792, US 4410621, EP 215453 and DIELECTRIC 321312.

Preferred examples of the hexaarylbisimidazoles include 2,4,5,2' ,4' ,5'-hexaphenylbisimidazole, 2,2'-bis(2-chlorophenyl)-4,5,4',5'-tetraphenylbisimidazole, 2,2'-bis(2-bromophenyl)-4,5,4' ,5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)bisimidazole, 2,5,2' ,5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazale, 2,2'-di-o-tolyl-4,5,4',5'-tetraphenylbisimidazole, 2,2'-bis(2-ethoxyphenyl)-4,5,4',5'-tetraphenylbisimidazole, and 2,2'-bis(2,6-difluorophenyl)-4,5,4',5'-tetraphenylbisimidazole.

As the polymerization initiators used in combination, there are sulfonium salts or iodonium salts.

Examples of the sulfonium salts or iodonium salts include those disclosed in Japanese Patent O.P.I. Publication Nos. 2001-343742, 2002-6482, 2002-116539, 2002-148790, 2002-268217, 2002-341519, 2003-076010, and 2003-5363.

Diazo resins can be preferably used as polymerization initiators. Examples thereof include those disclosed in Japanese Patent O.P.I. Publication No. 10-31307.

The content of the polymerization initiator in the light-sensitive layer is not specifically limited, but is preferably from 0.1 to 20% by weight, and more preferably from 0.8 to 15% by weight.

### (Polymerizable compound)

The polymerizable compound is a compound whose polymerization is initiated by a reaction product produced from a polymerization initiator on light exposure. The polymerizable compound in the invention is a compound whose polymerization is initiated by a radical species generated from the polymerization initiator in the invention on light exposure.

The polymerizable compound used in the invention is preferably a compound having an ethylenically double bond (hereinafter also referred to as an ethylenically unsaturated compound). As the ethylenically unsaturated compound, there are a conventional radical polymerizable monomer, and a polyfunctional monomer or oligomer having two or more of an ethylenic double bond in the molecule generally used in an ultraviolet curable resin composition.

In the invention, the content of the polymerizable compound in the light sensitive layer is preferably from 10 to 70% by weight, and more preferably from 20 to 60% by weight.

The ethylenically unsaturated compound is not specifically limited. Preferred examples thereof include a monofunctional acrylate such as 2-ethylhexyl acrylate, 2-hydroxypropyl acrylate, glycerol acrylate, tetrahydrofurfuryl acrylate, phenoxyethyl acrylate, nonylphenoxyethyl acrylate, tetrahydrofurfuryl-oxyethyl acrylate, tetrahydrofurfuryloxyhexanorideacrylate, an ester of 1,3-dioxane-ε-caprolactone adduct with acrylic acid, or 1,3-dioxolane acrylate; a methacrylate, itaconate, crotonate or maleate alternative of the above acrylate; a bifunctional acrylate such as ethyleneglycol diacrylate, triethyleneglycol diacrylate, pentaerythritol diacrylate, hydroquinone diacrylate, resorcin diacrylate, hexanediol diacrylate, neopentyl glycol diacrylate, tripropylene glycol diacrylate, hydroxypivalic acid neopentyl glycol diacrylate, neopentyl glycol adipate diacrylate, diacrylate of hydroxypivalic acid neopentyl glycol-ε-caprolactone adduct, 2-(2-hydroxy-1,1-dimethylethyl)-5-hydroxymethyl-5-ethyl-1,3-dioxane diacrylate, tricyclodecanedimethylol acrylate, tricyclodecanedimethylol acrylate-ε-caprolactone adduct or 1,6-hexanediol diglycidylether diacrylate; a dimethacrylate, diitaconate, dicrotonate or dimaleate alternative of the above diacrylate; a polyfunctional acrylate such as trimethylolpropane triacrylate, ditrimethylolpropane tetraacrylate, trimethylolethane triacrylate, pentaerythritol triacrylate, pentaerythritol tetraacrylate, dipentaerythritol tetraacrylate, dipentaerythritol pentaacrylate, dipentaerythritol hexacrylate, dipentaerythritol hexacrylate-ε-caprolactone adduct, pyrrogallol triacrylate, propionic acid dipentaerythritol triacrylate, propionic acid dipentaerythritol tetraacrylate or hydroxypivalylaldehyde modified dimethylolpropane triacrylate; a methacrylate, itaconate, crotonate or maleate alternative of the above polyfunctional acrylate.

Prepolymers can be used, and as the prepolymers, there can be used a compound described later and a prepolymer to which photopolymerization property is given by incorporating an acryloyl or methacryloyl group into an oligomer having an appropriate molecular weight. These prepolymers can be used singly, in combination, or as an admixture thereof with the above described monomers and/or oligomers.

Examples of the prepolymer include polyester (meth)acrylate obtained by incorporating (meth)acrylic acid in a polyester of a polybasic acid such as adipic acid, trimellitic acid, maleic acid, phthalic acid, terephthalic acid, hymic acid, malonic acid, succinic acid, glutaric acid, itaconic acid, pyromellitic acid, fumalic acid, pimelic acid, sebatic acid, dodecanic acid or tetrahydrophthalic acid with a polyol such as ethylene glycol, ethylene glycol, diethylene glycol, propylene oxide, 1,4-butane diol, triethylene glycol, tetraethylene glycol, polyethylene glycol, grycerin, trimethylol propane, pentaerythritol, sorbitol, 1,6-hexanediol or 1,2,6-hexanetriol; an epoxyacrylate such as bisphenol A·epichlorhydrin·(meth)acrylic acid or phenol novolak·epichlorhydrin·(meth)acrylic acid obtained by incorporating (meth)acrylic acid in an epoxy resin; an urethaneacrylate such as ethylene glycol·adipic acid-tolylenediisocyanate-2-hydroxyethylacrylate, polyethylene glycol-tolylenediisocyanate-2-hydroxyethylacrylate, hydroxyethylphthalyl methacrylate-xylenediisocyanate, 1,2-polybutadieneglycol·tolylenediisocyanate·2-hydroxyethylacrylate or trimethylolpropane-propylene glycol-tolylenediisocyanate-2-hydroxyethylacrylate, obtained by incorporating (meth)acrylic acid in an urethane resin; a silicone acrylate such as polysiloxane acrylate, or polysiloxane·diisocyanate·2-hydroxyethylacrylate; an alkyd modified acrylate obtained by incorporating a methacroyl group in an oil modified alkyd resin; and a spiran resin acrylate.

The light sensitive layer in the invention may contain a monomer such as a phosphazene monomer, triethylene glycol, an EO modified isocyanuric acid diacrylate, an EO modified isocyanuric acid triacrylate, dimethyloltricyclodecane diacrylate, trimethylolpropane acrylate benzoate, an alkylene glycol acrylate, or a urethane modified acrylate, or an addition polymerizable oligomer or prepolymer having a structural unit derived from the above monomer.

As the ethylenically unsaturated compound used, there is a phosphate compound having at least one (meth)acryloyl group. The phosphate compound is a compound having a (meth)acryloyl group in which at least one hydroxyl group of phosphoric acid is esterified, but is not specifically limited as long as it has a (meth)acryloyl group.

Besides the above compounds, compounds disclosed in Japanese Patent O.P.I. Publication Nos. 58-212994, 61-6649, 62-46688, 62-48589, 62-173295, 62-187092, 63-67189, and 1-244891, compounds described on pages 286 to 294 of "11290 Chemical Compounds" edited by Kagakukogyo Nipposha, and compounds described on pages 11 to 65 of "UV·EB Koka Handbook (Materials)" edited by Kobunshi Kankokai can be suitably used. Of these compounds, compounds having two or more acryl or methacryl groups in the molecule are preferable, and those having a molecular weight of not more than 10,000, and preferably not more than 5,000 are more preferable.

In the invention, an addition polymerizable ethylenically unsaturated monomer having a tertiary amino group in the molecule is preferably used. Its molecular structure is not limited, but those are preferred in which a tertiary amine having a hydroxyl group is modified with glycidyl methacrylate, methacrylic chloride, or acrylic chloride. Examples thereof include a polymerizable compound disclosed I Japanese Patent O.P.I. Publication Nos. 1-165613, 1-203413 and 1-197213.

A reaction product of a polyhydric alcohol having a tertiary amino group in the molecule, a diisocyanate and a compound having a hydroxyl group and an addition polymerizable ethylenically double bond in the molecule is preferably used in the invention.

Examples of the polyhydric alcohol having a tertiary amino group in the molecule include triethanolamine, N-methyldiethanolamine, N-ethyldiethanolamine, N-ethyldiethanolamine, N-n-butyldiethanolamine, N-tert-butyldiethanolamine, N,N-di(hydroxyethyl)aniline, N,N, N', N'-tetra-2-hydroxypropylethylenediamine, p-tolyldiethanolamine, N,N, N', N'-tetra-2-hydroxyethylethylenediamine, N,N-bis(2-hydroxypropyl)aniline, allyldiethanolamine, 3-dimethylamino-1,2-propane diol, 3-diethylamino-1,2-propane diol, N,N-di(n-propylamino)-2,3-propane diol, N,N-di(iso-propylamino)-2,3-propane diol, and 3-(N-methyl-N-benzylamina)-1,2-propane diol, but the invention is not specifically limited thereto.

Examples of the diisocyanate include butane-1,4-diisocyanate, hexane-1,6-diisocyanate, 2-methylpentane-1,5-diisocyanate, octane-1,8-diisocyanate, 1,3-diisocyanatomethylcyclohexanone, 2,2,4-trzmethylhexane-1,6-diisocyanate, isophorone diisocyanate, 1,2-phenylene diisocyanate, 1,3-phenylene diisocyanate, 1,4-phenylene diisocyanate, tolylene-2,4-diisocyanate, tolylene-2,5-diisocyanate, tolylene-2,6-diisocyanate, 1,3-di(isocyanatomethyl)benzene, and 1,3-bis(1-isocyanato-1-methylethyl)benzene, but the invention is not specifically limited thereto.

Examples of the compound having a hydroxyl group and an addition polymerizable ethylenically double bond in the molecule include compounds MH-1 through MH-13 described below.

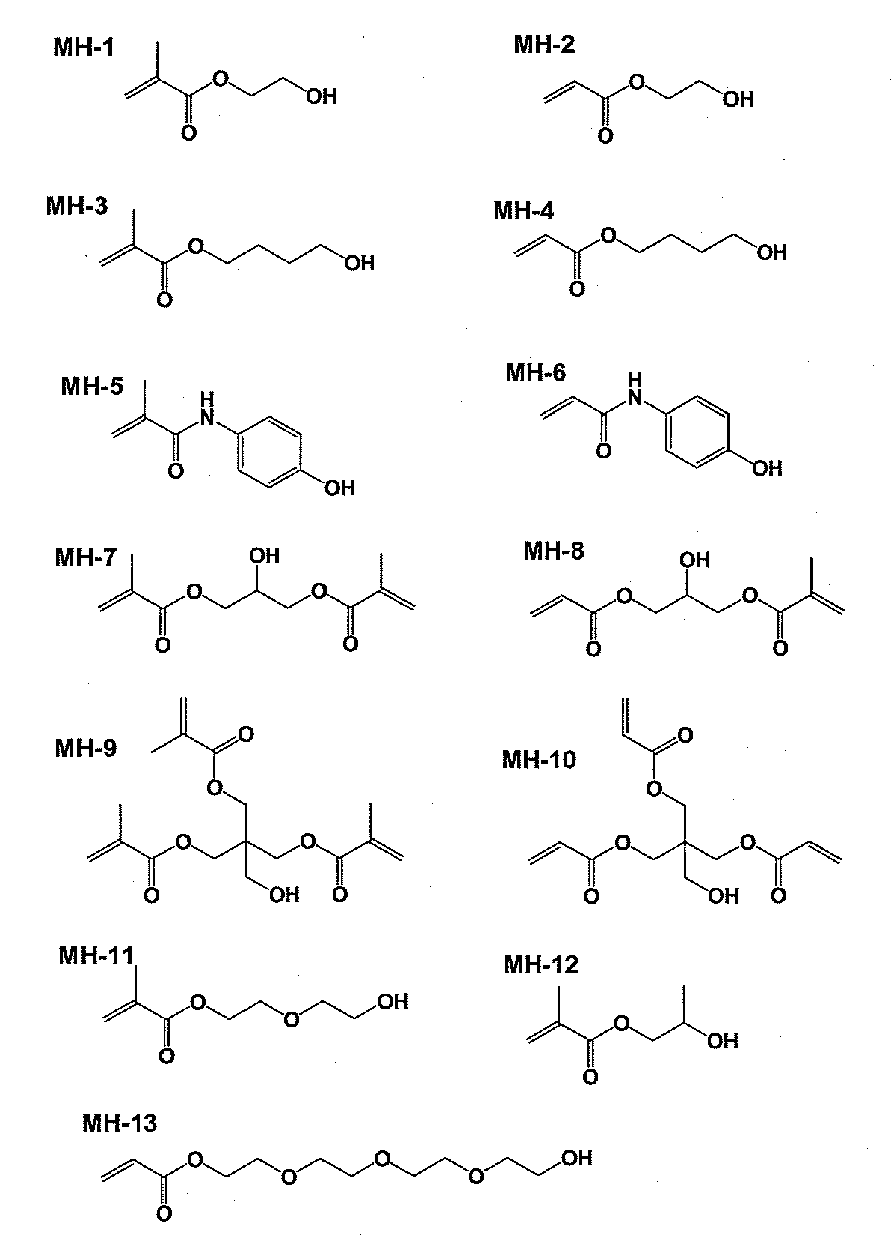

Preferred examples thereof include 2-hydroxyethyl methacrylate, 2-hydroxyethyl acrylate, 4-hydroxybutyl acrylate, 2-hydroxypropylene-1,3-dimethacrylate, and 2-hydroxypropylene-1-methacrylate-3-acrylate.

The reaction product above can be synthesized according to the same method as a conventional method in which a urethane acrylate compound is ordinarily synthesized employing an ordinary diol, a diisocyanate and an acrylate having a hydroxyl group.

Examples of the reaction product of a polyhydric alcohol having a tertiary amino group in the molecule, a diisocyanate and a compound having a hydroxyl group and an addition polymerizable ethylenically double bond in the molecule will be listed below.
M-1: A reaction product of triethanolamine (1 mole), hexane-1,6-diisocyanate (3 moles), and 2-hydroxyethyl methacrylate (3 moles)
M-2: A reaction product of triethanolamine (1 mole), isophorone diisocyanate (3 moles), and 2-hydroxyethyl methacrylate (3 moles)
M-3: A reaction product of N-n-butyldiethanolamine (1 mole), 1,3-bis(1-cyanato-1-methylethyl)benzene (2 moles), and 2-hydroxypropylene-1-methacrylate-3-acrylate (2 moles)
M-4: A reaction product of N-n-butyldiethanolamine (1 mole), 1,3-di(cyanatomethyl)benzene (2 moles), and 2-hydroxypropylene-1-methacrylate-3-acrylate (2 moles)
M-5: A reaction product of N-methydiethanolamine (1 mole), tolylene-2,4-diisocyanate (2 moles), and 2-hydroxypropylene-1,3-dimethacrylate (2 moles)
M-6: A reaction product of triethanolamine (1 mole), 1,3-bis (1-cyanato-1-methylethyl)benzene (3 moles), and 2-hydroxyethyl methacrylate (3 moles)
M-7: A reaction product of ethylenediamine tetraethanol (1 mole), 1,3-bis (1-cyanato-1-methylethyl)benzene (4 moles), and 2-hydroxyethyl methacrylate (4 moles)
M-8: A reaction product of butyldiethanolamine (1 mole), 1,3-bis(1-cyanato-1-methylethyl)benzene (2 moles) and 2-hydroxy-3-acryloyloxypropyl methacrylate (2 moles)

In addition to the above, acrylates or methacrylates disclosed in Japanese Patent O.P.I. Publication Nos. 1-105238 and 2-127404 can be used.

### (Polymer binder)

The polymer binder in the invention is one having a function of carrying components contained in the light sensitive layer.

The weight average molecular weight of the polymer binder in the invention is not specifically limited, but is in the range of from preferably 5,000 to 200,000, and more preferably from preferably 10,000 to 100,000.

As the polymer binder in the invention can be used a polyacrylate resin, a polyvinylbutyral resin, a polyurethane resin, a polyamide resin, a polyester resin, an epoxy resin, a phenol resin, a polycarbonate resin, a polyvinyl butyral resin, a polyvinyl formal resin, a shellac resin, or another natural resin. These resins can be used as an admixture of two or more thereof.

Among these, an alkali soluble polymer is preferably used. The alkali soluble polymer has a specific acid value, and has an acid value of preferably from 5 to 200, more preferably from 10 to 150, and most preferably 10 to 120.

A resin having in the molecule a carboxyl group or a hydroxyl group is preferred, and a resin having in the molecule a carboxyl group is more preferred.

The polymer binder used in the invention is preferably a vinyl copolymer obtained by copolymerization of an acryl monomer, and more preferably a copolymer containing, as the copolymerization component, (a) a carboxyl group-containing monomer unit and (b) an alkyl methacrylate or alkyl acrylate unit.

Examples of the carboxyl group-containing monomer include an α, β-unsaturated carboxylic acid, for example, acrylic acid, methacrylic acid, maleic acid, maleic anhydride, itaconic acid, itaconic anhydride or a carboxylic acid such as a half ester of phthalic acid with 2-hydroxymethacrylic acid.

Examples of the alkyl methacrylate or alkyl acrylate include an unsubstituted alkyl ester such as methylmethacrylate, ethylmethacrylate, propylmethacrylate, butylmethacrylate, amylmethacrylate, hexylmethacrylate, heptylmethacrylate, octylmethacrylate, nonylmethacrylate, decylmethacrylate, undecylmethacrylate, dodecylmethacrylate, methylacrylate, ethylacrylate, propylacrylate, butylacrylate, amylacrylate, hexylacrylate, heptylacrylate, octylacrylate, nonylacrylate, decylacrylate, undecylacrylate, or dodecylacrylate; a cyclic alkyl ester such as cyclohexyl methacrylate or cyclohexyl acrylate; and a substituted alkyl ester such as benzyl methacrylate, 2-chloroethyl methacrylate, N,N-dimethylaminoethyl methacrylate, glycidyl methacrylate, benzyl acrylate, 2-chloroethyl acrylate, N,N-dimethylaminoethyl acrylate or glycidyl acrylate.

The polymer binder in the invention can further contain, as another monomer unit, a monomer unit derived from the monomer described in the following items (1) through (14):
1) A monomer having an aromatic hydroxy group, for example, o-, (p- or m-) hydroxystyrene, or o-, (p- or m-) hydroxyphenylacrylate;
2) A monomer having an aliphatic hydroxy group, for example, 2-hydroxyethyl acrylate, 2-hydroxyethyl methacrylate, N-methylolacrylamide, N-methylolmethacrylamide, 4-hydroxybutyl acrylate, 4-hydroxybutyl methacrylate, 5-hydroxypentyl acrylate, 5-hydroxypentyl methacrylate, 6-hydroxyhexyl acrylate, 6-hydroxyhexyl methacrylate, N-(2-hydroxyethyl)acrylamide, N-(2-hydroxyethyl)methacrylamide, or hydroxyethyl vinyl ether;
3) A monomer having an aminosulfonyl group, for example, m- or p-aminosulfonylphenyl methacrylate, m- or p-aminosulfonylphenyl acrylate, N-(p-aminosulfonylphenyl) methacrylamide, or N-(p-aminosulfonylphenyl)acrylamide;
4) A monomer having a sulfonamido group, for example, N-(p-toluenesulfonyl)acrylamide, or N-(p-toluenesulfonyl)-methacrylamide;
5) An acrylamide or methacrylamide, for example, acrylamide, methacrylamide, N-ethylacrylamide, N-hexylacrylamide, N-cycLohexylacrylamide, N-phenylacrylamide, N-nitrophenylacrylamide, N-ethyl-N-phenylacrylamide, N-4-hydroxyphenylacrylamide, or N-4-hydroxyphenylmethacrylamide;
6) A monomer having a fluorinated alkyl group, for example, trifluoromethyl acrylate, trifluoromethyl methacrylate, tetrafluoropropyl methacrylate, hexafluoropropyl methacrylate, octafluoropentyl acrylate, octafluoropentyl methacrylate, heptadecafluorodecyl methacrylate, heptadecafluorodecyl methacrylate, or N-butyl-N-(2-acryloxyethyl)heptadecafluorooctylsulfonamide;
7) A vinyl ether, for example, ethyl vinyl ether, 2-chloroethyl vinyl ether, propyl vinyl ether, butyl vinyl ether, octyl vinyl ether, or phenyl vinyl ether;
8) A vinyl ester, for example, vinyl acetate, vinyl chroloacetate, vinyl butyrate, or vinyl benzoate;
9) A styrene, for example, styrene, methylstyrene, or chloromethystyrene;
10) A vinyl ketone, for example, methyl vinyl ketone, ethyl vinyl ketone, propyl vinyl ketone, or phenyl vinyl ketone;
11) An olefin, for example, ethylene, propylene, isobutylene, butadiene, or isoprene;
12) N-vinylpyrrolidone, N-vinylcarbazole, or N-vinylpyridine,
13) A monomer having a cyano group, for example, acrylonitrile, methacrylonitrile, 2-pentenenitrile, 2-methyl-3-butene nitrile, 2-cyanoethyl acrylate, or o-, m- or p-cyanostyrene;
14) A monomer having an amino group, for example, N,N-diethylaminoethyl methacrylate, N,N-dimethylaminoethyl acrylate, N,N-dimethylaminoethyl methacrylate, polybutadiene urethane acrylate, N,N-dimethylaminopropyl acrylamide, N,N-dimethylacrylamide, acryloylmorpholine, N-isopropylacrylamide, or N,N-diethylacrylamide.

Further another monomer may be copolymerized with the above monomer.

The above vinyl polymer can be manufactured according to a conventional solution polymerization, bulk polymerization or suspension polymerization. A polymerization initiator used is not specifically limited, but examples thereof include azo bis type radical generating agents, for example, 2,2'-azobisiso-butyronitrile (ATBN) or 2,2'-azobis(2-methylbutyronitrile. The amount used of the polymerization initiator is ordinarily from 0.05 to 10.0 part by weight (preferably from 0.1 to 5 part by weight), based on 100 parts by weight of monomer used to prepare a (co)polymer. As the solvents used in the solution polymerization, there are organic solvents including ketones, esters or aromatics, for example, good solvents generally used in the solution polymerization such as toluene, ethyl acetate, benzene, methylcellosolve, ethylcellosolve, acetone, and methyl ethyl ketone. Among these, ones having a boiling point of from 60 to 120 °C are preferred. The solution polymerization is ordinarily carried out at 40 to 120 °C (preferably 60 to 110 °C), for 3 to 10 hours (preferably 5 to 8 hours) employing the above solvents. After completion of polymerization, the solvents are removed from the resulting polymerization solution to obtain a (co)polymer. Alternatively, the polymerization solution is used without removing the solvents in a double bond incorporation reaction as described later which follows.

The molecular weight of the polymer can be adjusted by selecting solvents used or by controlling polymerization temperature. The solvents used or the polymerization temperature for obtaining a polymer with an intended molecular weight is appropriately determined by monomers used. The molecular weight of the polymer can be also adjusted by mixing the above solvents with a specific solvent. Examples of the specific solvent include mercaptans such as n-octylmercaptan, n-dodecylmercaptan, t-dodecylmercaptan and mercaptoethanol, and carbon chlorides such as carbon tetrachloride, butyl chloride and propylene chloride. The mixing ratio of the specific solvent to the solvents described above can be properly determined by monomers used, solvents used or polymerization conditions.

The polymer binder is preferably a vinyl polymer having in the side chain a carboxyl group and a polymerizable double bond.

As the polymer binder is also preferred an unsaturated bond-containing copolymer which is obtained by reacting a carboxyl group contained in the above vinyl copolymer molecule with for example, a compound having a (meth)acryloyl group and an epoxy group. Examples of the compound having a (meth)acryloyl group and an epoxy group in the molecule include glycidyl acrylate, glycidyl methacrylate and an epoxy group-containing unsaturated compound disclosed in Japanese Patent O.P.I. Publication No. 11-27196.

Further, an unsaturated bond-containing copolymer which is obtained by reacting a hydroxyl group contained in the above vinyl copolymer molecule with for example, a compound having a (meth)acryloyl group and an isocyanate group. Examples of the compound having a (meth)acryloyl group and an isocyanate group in the molecule include vinyl isocyanate, (meth)acryl isocyanate, 2-(meth)acroyloxyethyl isocyanate, m-or p-isopropenyl-α,α'-dimethylbenzyl isocyanate, and (meth)acryl isocyanate, or 2-(meth)acroyloxyethyl isocyanate is preferred.

Reaction of a carboxyl group existing in the molecule of the vinyl copolymer with a compound having in the molecule a (meth)acryloyl group and an epoxy group can be carried out according to a well-known method. For example, the reaction is carried out at a temperature of 20 to 100 °C, and preferably 40 to 80 °C, and more preferably at a boiling point of solvent used (while refluxing), for 2 to 10 hours and preferably 3 to 6 hours.

As the solvent used in the reaction, there are solvents used in the polymerization to obtain the vinyl copolymer above. After polymerization, the solvent in the polymerization can be used without being removed from the polymerization solution as a reaction solvent used for reaction in which an aliphatic epoxy group-containing unsaturated compound is incorporated into the vinyl copolymer. The reaction can be carried out in the presence of a catalyst or a polymerization inhibitor. As the catalyst, there are amines or ammonium chlorides. Examples of the amines include triethylamine, tributylamine, dimethylaminoethanol, diethylaminoethanol, methylamine, ethylamine, n-propylamine, i-propylamine, 3-methoxypropylamine, butylamine, allylamine, hexylamine, 2-ethylhexylamine, and benzylamine. Examples of the ammonium chlorides include triethylbenzylammonium chloride. The amount used of the catalyst is ordinarily from 0.01 to 20.0% by weight based on the weight of an aliphatic epoxy group-containing unsaturated compound used. Examples of the polymerization inhibitor include hydroquinone, hydroquinone monometyl ether, t-butylhydroquinone, 2,5-di-t-butylhydroquinone, methylhydroquinone, p-benzoquinone, methyl-p-benzoquinone, t-butyl-p-benzoquinone, and 2,5-diphenyl- p-benzoquinone. The amount used of the polymerization inhibitor is ordinarily from 0.01 to 5.0% by weight based on the weight of an aliphatic epoxy group-containing unsaturated compound used.

Reaction of a hydroxyl group existing in the molecule of the vinyl copolymer with a compound having in the molecule a (meth)acryloyl group and an isocyanate group can be carried out according to a known method. For example, the reaction is carried out at a temperature of 20 to 100 °C, and preferably 40 to 80 °C, and more preferably at a boiling point of solvent used (while refluxing), for 2 to 10 hours and preferably 3 to 6 hours. As the solvent used in the reaction, there are solvents used in the polymerization to obtain the vinyl copolymer above. After polymerization, the solvent in the polymerization can be used without being removed from the polymerization solution as a reaction solvent used for reaction in which an isocyanate group-containing unsaturated compound is incorporated into the vinyl copolymer.

The reaction can be carried out in the presence of a catalyst or a polymerization inhibitor. As the catalyst, tin compounds or amines are preferably used. Examples of thereof include dibutyltin laurate, and triethylamine. The amount used of the catalyst is preferably from 0.01 to 20.0% by weight based on the weight of a double bond-containing compound used. Examples of the polymerization inhibitor include hydroquinone, hydroquinone monometyl ether, t-butylhydroquinone, 2,5-di-t-butylhydroquinone, methylhydroquinone, p-benzoquinone, methyl-p-benzoquinone, t-butyl-p-benzoquinone, and 2,5-diphenyl- p-benzoquinone. The amount used of the polymerization inhibitor is ordinarily from 0.01 to 5.0% by weight based on the weight of an aliphatic epoxy group-containing unsaturated compound used. The reaction process is controlled by measurement of infrared absorption spectra (IR) of the reaction mixture and the reaction is terminated at the time when the isocyanate absorption disappears.

The content of the vinyl polymer having in the side chain a carboxyl group and a polymerizable double bond is preferably from 50 to 100% by weight, and more preferably 100% by weight, based on the total weight of the polymer binder used.

The polymer binder content of the light sensitive layer is preferably from 10 to 90% by weight, more preferably from 15 to 70% by weight, and still more preferably from 20 to 50% by weight, in view of sensitivity.

### (Chain transfer agent)

The chain transfer agent is a compound added to a polymerization reaction mixture in order to control polymerization degree of polymer, which has function changing kinds of chain transfer substances in the chain

### polymerization process.

As the chain transfer agent in the invention, radical chain transfer agents as disclosed in EP 107792 are preferred in promoting or controlling polymerization of the polymerizable compound in the invention. As the preferred chain transfer agent, there is a mercapto compound. It is especially preferred that an aromatic heterocyclic mercapto compound represented by formula (RCT) below or a mercapto derivative compound is contained in the light sensitive layer in the invention.

Formula (RCT) Ar-SM

Wherein M represents a hydrogen atom or an alkali metal atom; and Ar represents an aromatic heterocyclic ring or an aromatic heterocyclic condensed ring each containing in the ring at least one atom selected from the group consisting of a nitrogen atom, a sulfur atom, an oxygen atom, a selenium atom and a tellurium atom. Preferred examples of the aromatic heterocyclic ring or aromatic heterocyclic condensed ring include a benzimidazole ring, a naphthimidazole ring, a benzothiazole ring, a naphthothiazole ring, a benzoxazole ring, a naphthoxazole ring, a benzoselenazole ring, a benzotellurazole ring, an imidazole ring, an oxazole ring, a pyrazole ring, a triazole ring, a triazine ring, a pyrimidine ring, a pyridazine ring, a pyrazine ring, a pyridine ring, a purine ring, a quinoline ring, and a quinazoline ring. An aromatic heterocyclic mercapto compound having a chemical structure other than the aforementioned may be used as the chain transfer agent in the invention.

Various additives which can be contained in the light sensitive layer, a support, a protective layer, a coating method of a light sensitive layer coating liquid on the support and a manufacturing method of a light sensitive planographic printing plate material will be explained below.

### (Various additives)

The light sensitive layer in the invention is preferably added with a polymerization inhibitor, in order to prevent undesired polymerization of the ethylenically unsaturated monomer during the manufacture or after storage of light sensitive planographic printing plate material.

Examples of the polymerization inhibitor include hydroquinone, p-methoxyphenol, di-t-butyl-p-cresol, pyrrogallol, t-butylcatechol, benzoquinone, 4,4'-thiobis (3-methyl-6-t-butylphenol), 2,2'-methylenebis (4-methyl-6-t-butylphenol), N-nitrosophenylhydroxylamine cerous salt, and 2-t-butyl-6-(3-t-butyl-6-hydroxy-5-mrthylbenzyl)-4-methylphenyl acrylate.

The polymerization inhibitor content is preferably 0.01 to 5% by weight based on the total solid content of the light sensitive layer. Further, in order to prevent undesired polymerization induced by oxygen, behenic acid or a higher fatty acid derivative such as behenic amide may be added to the layer. After the light sensitive layer is coated layer, the coated layer may be dried so that the higher fatty acid derivative is localized at the vicinity of the surface of the light sensitive layer. The content of the higher fatty acid derivative is preferably 0.5 to 10% by weight, based on the total solid content of the light sensitive layer.

A colorant can be also used. As the colorant can be used known materials including commercially available materials. Examples of the colorant include those described in revised edition "Ganryo Binran", edited by Nippon Ganryo Gijutu Kyoukai (publishe by Seibunndou Sinkosha), or "Color Index Binran". Pigment is preferred.

Kinds of the pigment include black pigment, yellow pigment, red pigment, brown pigment, violet pigment, blue pigment, green pigment, fluorescent pigment, and metal powder pigment. Examples of the pigment include inorganic pigment (such as titanium dioxide, carbon black, graphite, zinc oxide, Prussian blue, cadmium sulfide, iron oxide, or chromate of lead, zinc, barium or calcium); and organic pigment (such as azo pigment, thioindigo pigment, anthraquinone pigment, anthanthrone pigment, triphenedioxazine pigment, vat dye pigment, phthalocyanine pigment or its derivative, or quinacridone pigment).

Among these pigment, pigment is preferably used which does not substantially have absorption in the absorption wavelength regions of a spectral sensitizing dye used according to a laser for exposure. The absorption of the pigment used is not more than 0.05, obtained from the reflection spectrum of the pigment measured employing an integrating sphere and employing light with the wavelength of the laser used. The pigment content is preferably 0.1 to 10% by weight, and more preferably 0.2 to 5% by weight, based on the total solid content of the photopolymerizable light sensitive layer composition.

A purple pigment or a blue pigment is preferably utilized in view of absorption of light with the aforesaid photosensitive wavelength region and image visibility after development. Such pigments include, for example, Cobalt Blue, cerulean blue, Alkali Blue, Phonatone Blue 6G, Victoria Blue Lake, metal-free Phthalocyanine Blue, Phthalocyanine Fast Sky Blue, Indathrene Blue, indigo, Dioxane Violet, Isoviolanthrone Violet, Indanthrone Blue and Indanthrone BC. Among them, more preferable are Phthalocyanine Blue and Dioxane Violet.

A surfactant may be added to the light sensitive layer in order to improve coatability of the layer. A preferred surfactant is a fluorine-contained surfactant.

Further, in order to improve physical properties of the cured light sensitive layer, the layer can contain an inorganic filler or a plasticizer such as dioctyl phthalate, dimethyl phthalate or tricresyl phosphate. The content of such a material is preferably not more than 10% by weight, based on the total solid content of the light sensitive layer.

The solvents used in the preparation of the coating liquid for the light sensitive layer in the invention include an alcohol such as sec-butanol, isobutanol, n-hexanol, or benzyl alcohol; a polyhydric alcohol such as diethylene glycol, triethylene glycol, tetraethylene glycol, or 1,5-pentanediol; an ether such as propylene glycol monobutyl ether, dipropylene glycol monomethyl ether, or tripropylene glycol monomethyl ether; a ketone or aldehyde such as diacetone alcohol, cyclohexanone, or methyl cyclohexanone; and an ester such as ethyl lactate, butyl lactate, diethyl oxalate, or methyl benzoate.

In the above, explanation of a light sensitive layer coating liquid was made. The light sensitive layer in the invention is formed on a support by coating on the support the light sensitive layer coating liquid.

The coating amount of the light sensitive layer is preferably from 0.1 to 10 g/m², and more preferably from 0.5 to 5 g/m².

### Protective layer (Oxygen shielding layer)

In the invention, a protective layer is preferably provided on the light sensitive layer.

It is preferred that the protective layer (oxygen shielding layer) is highly soluble in the developer as described later (generally an alkaline solution). Polyvinyl alcohol or polyvinyl pyrrolidone is preferably used in the protective layer. Polyvinyl alcohol has the effect of preventing oxygen from transmitting and polyvinyl pyrrolidone has the effect of increasing adhesion between the oxygen shielding layer and the image formation layer.

Besides the above two polymers, the oxygen shielding layer may contain a water soluble polymer such as polysaccharide, polyethylene glycol, gelatin, glue, casein, hydroxyethyl cellulose, carboxymethyl cellulose, methyl cellulose, hydroxyethyl starch, gum arabic, sucrose octacetate, ammonium alginate, sodium alginate, polyvinyl amine, polyethylene oxide, polystyrene sulfonic acid, polyacrylic acid, or a water soluble polyamide.

In the planographic printing plate material in the invention, adhesive strength between the protective layer and the light sensitive layer is preferably not less than 35 mN/mm, more preferably not less than 50 mN/mm, and still more preferably not less than 75 mN/mm. Preferred composition of the protective layer is disclosed in Japanese Patent Application No. 8-161645.

The adhesive strength can be determined according to the following method. The adhesive tape with a sufficient adhesive force is applied on the protective layer, and then peeled together with the protective layer under the applied tape in the normal direction relative to the protective layer surface. Force necessary to peel the tape together with the protective layer is defined as adhesive strength.

The protective layer may further contain a surfactant or a matting agent. The protective layer is formed, coating on the photopolymerizable light sensitive layer a coating solution in which the above protective layer composition is dissolved in an appropriate coating solvent, and drying. The main solvent of the coating solution is preferably water or an alcohol solvent such as methanol, ethanol, or isopropanol.

The thickness of the protective layer is preferably 0.1 to 5.0 *µ*m, and more preferably 0.5 to 3.0 *µ*m.

### (Support)

The support used in the invention is a plate or a sheet capable of carrying the light sensitive layer and preferably has a hydrophilic surface on the side on which the light sensitive layer is to be provided.

As the supports used in the invention, a plate of a metal such as aluminum, stainless steel, chromium or nickel, or a plastic film such as a polyester film, a polyethylene film or a polypropylene film, which is deposited or laminated with the above-described metal can be used. Further, a polyester film, a polyvinyl chloride film or a nylon film whose surface is subjected to hydrophilization treatment can be used. Among the above, the aluminum plate is preferably used, and may be a pure aluminum plate or an aluminum alloy plate.

As the aluminum alloy, there can be used various ones including an alloy of aluminum and a metal such as silicon, copper, manganese, magnesium, chromium, zinc, lead, bismuth, nickel, titanium, sodium or iron. In the aluminum plate for the support, the surface is roughened for water retention.

It is preferable that the aluminum plate is subjected to degreasing treatment for removing rolling oil prior to surface roughening (graining). The degreasing treatments include degreasing treatment employing solvents such as trichlene and thinner, and an emulsion degreasing treatment employing an emulsion such as kerosene or triethanol. It is also possible to use an aqueous alkali solution such as caustic soda for the degreasing treatment. When an aqueous alkali solution such as caustic soda is used for the degreasing treatment, it is possible to remove soils and an oxidized film which can not be removed by the above-mentioned degreasing treatment alone. When an aqueous alkali solution such as caustic soda is used for the degreasing treatment, the resulting support is preferably subjected to desmut treatment in an aqueous solution of an acid such as phosphoric acid, nitric acid, sulfuric acid, chromic acid, or a mixture thereof, since smut is produced on the surface of the support. The surface roughening methods include a mechanical surface roughening method and an electrolytic surface roughening method electrolytically etching the support surface.

Though there is no restriction for the mechanical surface roughening method, a brushing roughening method and a honing roughening method are preferable.

Though there is no restriction for the electrolytic surface roughening method, a method, in which the support is electrolytically surface roughened in an acidic electrolytic solution, is preferred.

After the support has been electrolytically surface roughened, it is preferably dipped in an acid or an aqueous alkali solution in order to remove aluminum dust, etc. produced in the surface of the support. Examples of the acid include sulfuric acid, persulfuric acid, hydrofluoric acid, phosphoric acid, nitric acid and hydrochloric acid, and examples of the alkali include sodium hydroxide and potassium hydroxide. Among those mentioned above, the aqueous alkali solution is preferably used.

The dissolution amount of aluminum in the support surface is preferably 0.5 to 5 g/m². After the support has been dipped in the aqueous alkali solution, it is preferable for the support to be dipped in an acid such as phosphoric acid, nitric acid, sulfuric acid and chromic acid, or in a mixed acid thereof, for neutralization.

The mechanical surface roughening and electrolytic surface roughening may be carried out singly, and the mechanical surface roughening followed by the electrolytic surface roughening may be carried out.

After the surface roughening, anodizing treatment may be carried out. There is no restriction in particular for the method of anodizing treatment used in the invention, and known methods can be used. The anodizing treatment forms an anodization film on the surface of the support.

The support which has been subjected to anodizing treatment is optionally subjected to sealing treatment. For the sealing treatment, it is possible to use known methods using hot water, boiling water, steam, a sodium silicate solution, an aqueous dichromate solution, a nitrite solution and an ammonium acetate solution.

After the above treatment, the support is suitably undercoated with a water soluble resin such as polyvinyl phosphonic acid, a polymer or copolymer having a sulfonic acid in the side chain, or polyacrylic acid; a water soluble metal salt such as zinc borate; a yellow dye; an amine salt; and so on, for hydrophilization treatment. The sol-gel treatment support disclosed in Japanese Patent O.P.I. Publication No. 5-304358, which has a functional group capable of causing addition reaction by radicals as a covalent bond, is suitably used.

### (Coating)

In the invention, the above-described light sensitive layer coating liquid is coated on the support according to a coating conventional method, and dried to obtain a light sensitive planographic printing plate material.

Examples of the coating method include an air doctor coating method, a blade coating method, a wire bar coating method, a knife coating method, a dip coating method, a reverse roll coating method, a gravure coating method, a cast coating method, a curtain coating method, and an extrusion coating method.

A drying temperature of the coated light sensitive layer is preferably from 60 to 160 °C, more preferably from 80 to 140 °C, and still more preferably from 90 to 120 °C.

### (Imagewise exposure)

As a light source for recording an image on the light sensitive planographic printing plate material of the invention, a laser with an emission wavelength of from 350 to 450 nm is preferred.

Examples of light sources for imagewise exposure of the light sensitive planographic printing plate material include a He-Cd laser (441 nm), a combination of Cr:LiSAF and SHG crystals (430 nm) as a solid laser, and KnbO3, ring resonator (430 nm), AlGaInN (350-350 nm) or AlGaInN semiconductor laser (InGaN type semiconductor laser available on the market, 400-410 nm) as a semiconductor type laser.

When a laser is used for exposure, which can be condensed in the beam form, scanning exposure according to an image can be carried out, and direct writing is possible without using any mask material. When the laser is employed for imagewise exposure, a highly dissolved image can be obtained, since it is easy to condense its exposure spot in minute size.

As a laser scanning method by means of a laser beam, there are a method of scanning on an outer surface of a cylinder, a method of scanning on an inner surface of a cylinder and a method of scanning on a plane. In the method of scanning on an outer surface of a cylinder, laser beam exposure is conducted while a drum around which a recording material is wound is rotated, in which main scanning is represented by the rotation of the drum, while sub-scanning is represented by the movement of the laser beam. In the method of scanning on an inner surface of a cylinder, a recording material is fixed on the inner surface of a drum, a laser beam is emitted from the inside, and main scanning is carried out in the circumferential direction by rotating a part of or an entire part of an optical system, while sub-scanning is carried out in the axial direction by moving straight a part of or an entire part of the optical system in parallel with a shaft of the drum. In the method of scanning on a plane, main scanning by means of a laser beam is carried out through a combination of a polygon mirror, a galvano mirror and an Fθ lens, and sub-scanning is carried out by moving a recording medium. The method of scanning on an outer surface of a cylinder and the method of scanning on an inner surface of a cylinder are suitable for high density image recording, since it is easier to increase accuracy of an optical system.

In the invention, imagewise exposure is carried out at a plate surface energy (an exposure energy at the surface of the planographic printing plate material) of from 10 to 500 mJ/cm², and more preferably from 10 to 300 mJ/cm². This exposure energy can be measured, employing a laser power meter PDGDO-3W produced by Ophir Optronics Inc.

### (Developer)

In the manufacturing method of the invention of a planographic printing plate, the imagewise exposed light sensitive layer, which has been cured at exposed portions, is developed with an alkali developer, whereby the light sensitive layer at exposed portions are removed to form an image.

As the alkali developer, a conventional alkali aqueous solution is used. For example, there is an alkali developer containing an inorganic alkali agent such as sodium silicate, potassium silicate, ammonium silicate, sodium secondary phosphate, potassium secondary phosphate, ammonium secondary phosphate; sodium hydrogen carbonate, potassium hydrogen carbonate, ammonium hydrogen carbonate; sodium carbonate, potassium carbonate, ammonium carbonate; sodium borate, potassium borate, lithium borate; sodium hydroxide, potassium hydroxide, and ammonium hydroxide.

The alkali developer can contain organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine.

These alkali agents can be used singly or as a mixture of two or more thereof. The alkali developer can contain an anionic surfactant, an amphoteric surfactant, or an organic solvent such as alcohol.

The alkali developer can be prepared from a developing composition in the form of tablets or granules or a developer concentrate.

The developer concentrate may be prepared by forming a developer solution, followed by evaporation to dryness and is preferably prepared in such a manner that plural components are mixed with a small amount of water or without adding any water. The developer concentrate can also be prepared in the form of granules or tablets, as described in Japanese Patent O.P.I. Publication Nos. 51-61837, 2-109042, 2-109043, 3-39735, 5-142786, 6-266062 and 7-13341. The developer concentrate may be divided into plural parts differing in material species or compounding ratio.

The concentrate is used for development preferably by diluting with water to a prescribed concentration prior to development. When the developer concentrate is used as a developer replenisher, it is preferred that the developer concentrate is diluted with water to a prescribed concentration, followed by being supplied to a working developer, whereby it is also feasible to supply a developer at a higher concentration than the prescribed one or, without being diluted to the prescribed concentration, to the working developer. When supplied at a higher concentration than the prescribed one or without being diluted to the prescribed concentration, water may be separately added in the same timing or in a different timing.

The developer concentrate has a water content of preferably not more than 10% by weight, and more preferably not more than 1% by weight, based on the concentrate. The higher water content often causes problems such that developer components separate out in water, losing homogeneity or becomes liquid, making handling hard. Components contained in a developer for a conventional lithographic printing plate material can be employed as the components for the developer concentrate and it is preferred to exclude a component which reacts at a water content of not more than 10% by weight and cannot be recovered even with dilution, a material having a large moisture content or a liquid material at ordinary temperature. For example, a silicate petrifies at a reduced water content and becomes hard to be solved. Therefore, carbonates, phosphates or organic acid salts described later are contained in the developer concentrate instead of silicates. Carbonates are especially preferred.

Components contained in the developer concentrate will be explained below. Explanation is made on those of both developer concentrate and developer replenisher concentrate, unless otherwise specified. The term "developer" refers to a developer or developer replenisher after the concentrate has been diluted with a given amount of water.

### (Alkali reagent)

Examples of an inorganic alkali reagent include sodium tertiary phosphate, potassium tertiary phosphate, ammonium tertiary phosphate, sodium carbonate, potassium carbonate, ammonium carbonate, sodium hydrogen carbonate, potassium hydrogen carbonate, ammonium hydrogen carbonate, sodium borate, potassium borate, ammonium borate, sodium hydroxide, potassium hydroxide, ammonium hydroxide, and lithium hydroxide. Examples of an organic alkali reagent include monomethhylamine, dimethylamine, trimethylamine, monoethylamine, diethylamine, triethylamine, monoisobutylamine, diisobutylamine, triisobutylamine, n-butylamine, monoethanolamine, diethanolamine, triethanolamine, monoisopropanolamine, diisopropanolamine, ethyleneimine, ethylenediamine, pyridine, and tetramethylammonium hydroxide.

The alkali reagents can be used alone or in combination thereof. An alkali reagent is used preferably in an amount giving a pH of 9 to 13.5, and more preferably 10.0 to 12.5, and an electric conductivity of 2 to 40 mS/cm, more preferably 3 to 30 mS/cm, and still more preferably 5 to 20 mS/cm) when used as a developer (or developer solution). A pH lower than the foregoing range results in no image formation and a pH exceeding the foregoing range often causes over-development, leading to increased damages in development at exposed areas. A conductivity lower than the foregoing range usually renders difficult dissolution of the light sensitive layer provided on the surface of an aluminum plate support, leading to stained printing. A conductivity exceeding the foregoing range results in an increased salt concentration, retarding dissolution of the light sensitive layer, resulting in residual layer at unexposed areas.

The developer concentrate in the invention preferably contains a nonionic surfactant having a polyoxyalkylene ether group. Addition of such a surfactant promotes dissolution of the light sensitive layer in unexposed areas and minimizes penetration of a developer to exposed areas. As the surfactant having a polyoxyalkylene ether group is suitably used a compound represented by the following formula (AO): Formula (AO)

R₁-O- (R₂-O)ₙH

wherein R₁ is an alkyl group having 3 to 15 carbon atoms, an aromatic hydrocarbon group having 6 to 16 carbon atoms or an aromatic heterocyclic group having 4 to 15 carbon atoms, each of which may have a substituent, (examples of the substituent include an alkyl group having 1 to 20 carbon atoms, a halogen atom such as Br, Cl or I, an aromatic hydrocarbon group having 6 to 15 carbon atoms, an aralkyl group having 7 to 17 carbon atoms, an alkoxy group having 1 to 20 carbon atoms, an alkoxycarbonyl group having 2 to 20 carbon atoms and an acyl group having 2 to 15 carbon atoms); R₂ is an alkylene group having 1 to 100 carbon atoms, which may have a substituent (examples of the substituent include an alkyl group having 1 to 20 carbon atoms and an aromatic hydrocarbon group having 6 to 15 carbon atoms); and n is an integer of 1 to 100.

In formula (AO), (R₂-O)ₙ may be comprised of a combination of two or three kinds thereof, as long as it falls within the above-described range. Typical examples thereof include those in which a combination of an ethylene oxy group and a propyleneoxy group, an ethylene oxy group and an isopropyleneoxy group, an ethylene oxy group and butyleneoxy group, or an ethylene oxy group and an isobutyleneoxy group is arranged randomly or in block form.

Surfactants having a polyoxyalkylene ether group, which may be used alone or in their combination, are added to a developer, preferably in an amount of 1 to 30%, and more preferably 2 to 20% by weight. A lesser addition amount lowers developability and an excessive addition results in increased damages in development, leading to lowering of printing durability of printing plate.

There may be incorporated other surfactants. Examples thereof include nonionic surfactants including polyoxyethylene alkyl ethers such as polyoxyethylene lauryl ether, polyoxyethylene cetyl ether and polyoxyethylene stearyl ether; polyoxyethylene alkylaryl ethers such as polyoxyethylene octylphenyl ether and polyoxyethylene nonylphenyl ether; polyoxyethylene alkyl esters such as polyoxyethylene stearate; sorbitan alkyl esters such as sorbitan monolaurate, sorbitan monostearate, sorbitan distearate and sorbitan trioleate; monoglyceride alkyl esters such as glycerol monostearate and glycerol monooleate: anionic surfactants including alkylbebzenesulfonates such as sodium dodecylbenzenesulfonate; alkylnaphthalenesulfonates such as sodium butylnaphthalenesulfonate, sodium pentylnaphthalenesulfonate, sodium hexylnaphthalenesulfonate and sodium octylnaphthalenesulfonate; alkylsulfates such as sodium laurylsulfate; alkyl sulfonates such as sodium dodecylsulfonate; sulfosuccinic acid esters such as sodium dilaurylsulfosuccinate: amphoteric surfactants including alkylbetaines such as laurylbetaine and allylbetaine; and amino acids. Of these surfactants, anionic surfactants such as alkylnaphthalenesulfonates are specifically preferred.

These surfactants may be used alone on in their combination. These surfactants are preferably contained in an effective amount (in terms of solids) of 0.1 to 20% by weight.

In addition to the components described above, the developer concentrate in the invention may optionally contain additives such as an organic solvent, a chelating agent, a reducing agent, dye, pigment, a water-softening agent, an antiseptic agent and a defoaming agent.

### (Development stabilizing agent)

The developer concentrate preferably contains a development stabilizing agent. The preferred examples of the development stabilizing agent include an adduct of sugar alcohol with polyethylene glycol, tetraalkylammonium hydroxide such as tetrabutylammonium hydroxide, a phosphonium salt such as tetrabutylphosphonium bromide, and an iodonium salt such as diphenyliodonium chloride, as disclosed in Japanese Patent O.P.I. Publication No. 6-282079. Examples of the development stabilizing agent include anionic surfactants or amphoteric surfactants disclosed in Japanese Patent O.P.I. Publication No. 50-51324, water soluble cationic polymers disclosed in Japanese Patent O.P.I. Publication No. 55-95946, and water soluble amphoteric surfactants disclosed in Japanese Patent O.P.I. Publication No. 56-142528. Further, the examples include organic boron-containing compound to which alkylene glycol is added, disclosed in Japanese Patent O.P.I. Publication No.59-84241, polyoxyethylene-polyoxypropylene block polymer type water-soluble surfactant, disclosed in Japanese Patent O.P.I. Publication No.60-111264, an alkylenediamine compound having polyoxyethylene-polyoxypropylene, disclosed in Japanese Patent O.P.I. Publication No.60-129750, polyoxyethylene, glycol with an average weight molecular weight of not less than 300 disclosed in Japanese Patent O.P.I. Publication No. 61-215554, a fluorine-containing surfactant having a cationic group disclosed in Japanese Patent O.P.I. Publication No.63-175858, and a water soluble ethyleneoxide adduct obtained by adding ethyleneoxy to an acid or an alcohol, or water soluble polyalkylenes disclosed in Japanese Patent O.P.I. Publication No. 2-39157.

### (Organic solvent)

Organic solvents are optionally added to a developer or a developer replenisher. The organic solvent is a solvent having a solubility in water of suitably 10 weight % or less, and preferably 5 weight % or less. Examples of the organic solvent include 1-phenylethanol, 2-phenylethanol, 3-phenyl-1-propanol, 4-phenyl-1-butanol, 1-phenyl-2-butanol, 2-phonoxyethanol, 2-benzyloxyethanol, o-methoxybenzylalcohol, m-methoxybenzylalcohol, p-methoxybenzylalcohol, benzylalcohol, cyclohexanol, 2-methylcyclohexanol, 3-methylcyclohexanol, 4-methylcyclohexanol, N-phenylethanolamine, and N-phenyldiethanolamine. The organic solvent content of the working developer is preferably 0.1 to 5 weight %. It is preferred that the organic solvent content is not substantially contained in the developer or developer replenisher. The term "not substantially contained " means that the organic solvent is contained in an amount of not more than 1% by weight.

### (Reducing agent)

A reducing agent is optionally added to the developer concentrate used in the invention. This is added in order to prevent occurrence of stains on the printing plate during printing. The addition is particularly effective in developing a negative working light sensitive planographic printing plate precursor comprising a light sensitive diazonium compound. Preferred examples of the reducing agent include a phenolic compound such as thiosalicylic acid, hydroquinone, metol, methoxyquinone, resorcine, or 2-methylresorcine, and an amine compound such as phenylenediamine or phenylhydrazine. Preferred examples of the inorganic reducing agent include a sodium, potassium or ammonium salt of an inorganic acid such as sodium sulfite, potassium sulfite, ammonium sulfite, sodium phosphite, potassium phosphite, ammonium phosphite, sodium hydrogen phosphite, potassium hydrogen phosphite, ammonium hydrogen phosphite, sodium thiosulfate, potassium thiosulfate, ammonium thiosulfate, sodium dithionite, potassium dithionite, ammonium dithionite. It is sulfite of these that shows excellent anti-staining effect. The reducing agent content of the developer is preferably 0.05 to 5% by weight.

### (Organic carboxylic acid)

An organic carboxylic acid is optionally added to the developer concentrate used in the invention. Preferred organic carboxylic acids include an aliphatic carboxylic acid or an aromatic carboxylic acid each having a carbon atom number of from 6 to 20.

Examples of the aliphatic carboxylic acid include caproic acid, enanthic acid, caprylic acid, lauric acid, myristic acid, palmitic acid, and stearic acid. Particularly preferred are alkanoic acids having a carbon atom number of from 8 to 12. The acid may be an unsaturated acid having a double bond in the molecule or may have a branched carbon chain. The aromatic carboxylic acid is an aromatic compound such as benzene, naphthalene or anthracene having a carboxyl group- Examples of the aromatic carboxylic acid include o-chlorobenzoic acid, p-chlorobenzoic acid, o-hydroxybenzoic acid, p-hydroxybenzoic acid, o-aminobenzoic acid, p-aminobenzoic acid, 2,4-dihydroxybenzoic acid, 2,5-dihydroxybenzoic acid, 2,6-dihydroxybenzoic acid, 2,3-dihydroxybenzoic acid, 3,5-dihydroxybenzoic acid, gallic acid, 1-hydroxy-2-naphthoic acid, 3-hydroxy-2-naphthoic acid, 2-hydroxy-1-naphthoic acid, 1-naphthoic acid, and 2-naphthoic acid. Hydroxy naphthoic acids are especially preferred. These carboxylic acids are preferably used in the salt form, for example as the sodium salts, potassium salts or ammonium salts, in order to increase their water solubility. The organic carboxylic acid content of the developer is not specifically limited, but the content lass than 0.1% by weight does not exhibit advantageous effects, while the content exceeding 10% by weight cannot enhance the effects, and may prevent dissolution of other additives into the developer. Therefore, the organic carboxylic acid content of the working developer is preferably from 0.1 to 10% by weight, and more preferably from 0.5 to 4% by weight.

### (Other additives)

The developer concentrate in the invention may contain the following additives in order to increase development performance. Examples of the additives include a neutral salt such as sodium chloride, potassium chloride, potassium bromide, as dislosed in Japanese Patent O.P.I. Publication No. 58-75152, a complex such as [Co(NH₃)₆]Cl₃ as dislosed in Japanese Patent O.P.I. Publication No. 59-121336, an amphoteric polymer such as a copolymer of vinylbenzyl-trimethylammonium chloride and sodium acrylate as disclosed in Japanese Patent O.P.I. Publication No. 56-142258, the organic metal containing surfactant containing Si or Ti as disclosed in Japanese Patent O.P.I. Publication No. 59-75255, and the organic boron containing compound disclosed in Japanese Patent O.P.I. Publication No. 59-84241.

The developer or developer replenisher in the invention can further contain an antiseptic agent, a coloring agent, a viscosity increasing agent, an antifoaming agent, or a water softener. Examples of the antifoaming agent include mineral oil, vegetable oil, alcohols, surfactants, and silicon oil disclosed in Japanese Patent O.P.I. Publication No. 2-244143. The water softeners include polyphosphoric acid or its sodium, potassium or ammonium salt; aminopolycarboxylic acids or their salts such as ethylenediaminetetraacetic acid or its sodium, potassium or ammonium salt, diethylenetriaminepentaacetic acid or its sodium, potassium or ammonium salt, triethylenetetramine-hexaacetic acid or its sodium, potassium or ammonium salt, hydroxyethylethylenediaminetriacetic acid or its sodium, potassium or ammonium salt, nitrilotriacetic acid or its sodium, potassium or ammonium salt, 1,2-diaminocyclohexane-tetraacetic acid or its sodium, potassium or ammonium salt, 1,3-diamino-2-propanoltetraacetic acid or its sodium, potassium or ammonium salt; and phosphonic acids or their salts such as aminotri(methylenephosphonic acid) or its sodium, potassium or ammonium salt, ethylenediamznetetra-(methylenephosphonic acid) or its sodium, potassium or ammonium salt, diethylenetriaminepenta(methylenephosphonic acid) or its sodium, potassium or ammonium salt, triethylenetetraminehexa(methylenephosphonic acid) or its sodium, potassium or ammonium salt, hydroxyethyl-ethylenediaminetri(methylenephosphonic acid) or its sodium, potassium or ammonium salt, and 1-hydroxyethane-1,1-diphosphonic acid or its sodium, potassium or ammonium salt.

The water softener content of the developer varies on hardness or amount of a hard water used, but the content is preferably 0.01 to 5 weight %, and more preferably 0.01 to 0.5 weight %. The content less than the above range cannot attain the desired objects while the content exceeding the above range has an adverse effect on image areas such as dye elimination.

### (Automatic developing machine)

It is advantageous that an automatic developing machine is used in order to develop a light sensitive planographic printing plate material. It is preferred that the automatic developing machine is equipped with a means for replenishing a developer replenisher in a necessary amount, a means for discharging any excessive developer and a means for automatically replenishing water in necessary amounts which is attached to the development section. It is preferred that the automatic developing machine comprises a means for detecting a transported planographic printing plate precursor, a means for calculating the area of the planographic printing plate precursor based on the detection, or a means for controlling the replenishing amount of a developer replenisher, the replenishing amount of water to be replenished, or the replenishing timing. It is also preferred that the automatic developing machine comprises a means for detecting a pH, temperature and/or electric conductivity of a developer, or a means for controlling the replenishing amount of the developer replenisher, the replenishing amount of water to be replenished or the replenishing timing, based on the detection. It is also preferred to provide a mechanism of diluting the developer concentrate with water and of stirring the diluted concentrate. Where the developing step is followed by a washing step, washing water used for washing can be reused as dilution water for diluting the developer concentrate.

The automatic developing machine used in the invention may be provided with a pre-processing section to allow the plate to be immersed in a pre-processing solution prior to development. The pre-processing section is provided preferably with a mechanism of spraying a pre-processing solution onto the plate surface, preferably with a mechanism of controlling the pre-processing solution at a temperature within the range of 25 to 55 °C, and preferably with a mechanism of rubbing the plate surface with a roller-type brush. Common water and the like are employed as the pre-processing solution.

### (Post-processing)

The developed printing plate material is preferably subjected to post-processing. The post-processing step comprises post-processing the developed precursor with a post-processing solution such as washing water, a rinsing solution containing a surfactant, a finisher or a protective gumming solution containing gum arabic or starch derivatives as a main component. The post-processing step is carried out employing an appropriate combination of the post-processing solution described above. For example, a method is preferred in which a developed planographic printing plate precursor is post-washed with washing water, and then processed with a rinsing solution containing a surfactant, or a developed planographic printing plate precursor is post-washed with washing water, and then processed with a finisher, since it reduces fatigue of the rinsing solution or the finisher. It is preferred that a multi-step countercurrent processing is carried out employing a rinsing solution or a finisher.

The post-processing is carried out employing an automatic developing machine having a development section and a post-processing section. In the post-processing step, the developed printing plate is sprayed with the post-processing solution from a spray nozzle or is immersed into the post-processing solution in a post-processing tank. A method is known in which supplies a small amount of water onto the developed printing plate precursor to wash the precursor, and reuses the water used for washing as dilution water for developer concentrate. In the automatic developing machine, a method is applied in which each processing solution is replenished with the respective processing replenisher according to the area of the printing plate precursor to have been processed or the operating time of the machine. A method (use-and-discard method) can be applied in which the developed printing plate material is processed with fresh processing solution and discarded. The thus obtained planographic printing plate is mounted on a printing press, and printing is carried out.

### (Gum solution)

Gum solution may be suitably added with acids or buffers to remove from the developed plate alkaline ingredients which are contained in the developer. Further, there may be added a hydrophilic polymer compound, a chelating agent, a lubricant, an antiseptic and a solubilizing agent. Inclusion of the hydrophilic polymer compound in the gum solution provides a function as a protecting agent to prevent the developed plate from flawing or staining.

### (Washing water used prior to development)

Washing solution used in the washing stage prior to development invention is usually common water and may optionally be added with the following additives.

Chelating agents are used which are capable of coordination-bonding with a metal ion to form a chelate compound. Examples of the chelating agents include ethylenediaminetetraacetic acid and its potassium and sodium salts, ethylenediaminedisuccinic acid and its potassium and sodium salts, triethylenetetraminehexaacetic acid and its sodium and potassium salts, diethylenetriaminepentaacetic acid and its sodium and potassium salts, hydroxyethylethylenediaminetriacetic acid and its sodium and potassium salts, nitrilotriacetic acid and its sodium and potassium salts, 1-hydroxyethane-1,1-diphosphonic acid and its sodium and potassium salts, aminotri(methylenephosphonic acid) and its sodium and potassium salts and phosphonoalkanetricarboxylic acid. Besides the sodium and potassium salts of chelating agents, their organic amine salts are also effective. These chelating agents are contained in an amount of 0 to 3.0% by weight.

Surfactants usable in the invention include any one of anionic, nonionic, cationic and amphoteric surfactants, and anionic and nonionic surfactants are preferably used. The kind of preferred surfactants is different depending on the composition of an over-coat layer or photosensitive layer. In general are preferred surfactants which are capable of promoting dissolution of material used in the over-coat layer and exhibit less solubility for components of the photosensitive layer. Examples of the anionic surfactants include fatty acid salts, abietic acid salts, hydroxyalkanesulfonates, alkanesulfonates, dialkylsulfosuccinates, straight chain alkylbebzenesulfonates, branched alktlbebzenesulfonates, alkylnaphthalenesulfonates, alkylphenoxypolyoxyethylene propylsulfonates, polyoxyethylene alkylsulfophenyl ether, polyoxyethylene aryl ether sulfonic acid salts, polyoxyethylene-naphthyl ether sulfonic acid salts, N-metyl-N-oleyltaurine sodium salts, petroleum sulfonic acid salts, nitrated castor oil, sulfated tallow oil, fatty acid alkyl ester sulfuric acid ester salts, alkylnitrates, polyoxyethylene alkyl ether sulfuric acid ester salts, fatty acid monoglyceride sulfate ester salts, polyoxyethylene alkylphenyl ether sulfuric acid salts, alkylphosphate ester salts, polyoxyethylene alkyl ether phosphoric acid ester salts, polyoxyethylene alkylphenyl ether phosphoric acid ester salts, partially saponified styrene anhydrous maleic acid copolymer, partially saponified olefin-anhydrous maleic acid copolymer, and naphthalenesulfonate formaline condensates. Of the foregoing, dialkylsulfosuccinates, alkylsulfates and alkylnaphthalenesulfonates are preferred. Examples of the nonionic surfactants include polyoxyethylene alkyl ethers, polyoxyethylene alkylphenyl ethers, polyoxyethylene-polyoxypropylene block polymers, polyoxyethylene aryl ethers, polyoxyethylene naphthyl ethers, polyoxyethylene polystyrylphenyl ethers, polyoxyethylene polyoxypropylene alkyl ethers, glycerin fatty acid partial esters, sorbitan fatty acid partial esters, pentaerythritol fatyy acid partial esters, propylene glycol monofatty acid esters, sugar fatty acid partial esters, polyoxuethylen sorbitan fatty acid partial esters, polyoxyethylene sorbitol fatty acid partial esters, polyethylene glycol fatty acid partial esters, polyglycerin fatty acid partial esters, polyoxyethylene-modified caster oils, polyoxyethylene grycerin fatty acid partial esters, fatty acid diethanolamides, N,N-bis-2-hydroxyalkylamines, polyoxyethylene alkylamine, triethanolamine fatty acid esters and trialkylamineoxides. The surfactant is contained preferably in an amount of 0 to 10% by weight. The surfactant may be used in combination with defoaming agents.

Antiseptics usable in the invention include, for example, phenol and its derivatives, formaline, imidazole derivatives, sodium dehydroacetate, 4-isothiazoline-3-one derivatives, benzoisothiazoline-3-one, benzotriazole derivatives, amidinoguanine derivatives, quaternary ammonium salts, derivatives of pyridine, quinoline and guanine, diazine, triazole derivatives, oxazole, and oxazine derivatives.

In washing, a washing solution used prior to development is used preferably at a controlled temperature, and more preferably at 10 to 60 °C. Washing can be performed using commonly known solution-feeding techniques such as a spraying, dipping or coating method. During washing, a wash promoting method employing a brush, a squeezing roll or a submerged shower in a dipping treatment can be suitably used.

After completion of the washing stage prior to development, development may be immediately conducted, or drying may be conducted after the washing stage, subsequently, development may be performed. The development stage is followed by a post-treatment such as washing, rinsing or a gumming treatment. Washing water used prior to development may also be reused as washing water or for a rinsing solution or gumming solution.

### EXAMPLES

Next, the present invention will be explained in the following examples, but the present invention is not limited thereto. In the examples, "parts" represents "parts by weight", unless otherwise specified.

### (Synthesis of polymer binder)

### (Synthesis of acryl copolymer 1)

Thirty parts of methacrylic acid, 50 parts of methyl methacrylate, 20 parts of ethyl methacrylate, 250 parts of isopropyl alcohol, 250 parts of propylene glycol monomethyl ether acetate, and 3 parts of α,α'-azobisisobutyronitrile were put in a three neck flask under nitrogen atmosphere, and reacted under nitrogen atmosphere for 6 hours at 80°C in an oil bath.

After that, the reaction mixture was refluxed at a boiling point of isopropyl alcohol for one hour, and 3 parts of triethylbenzylammonium chloride and 25 parts of glycidyl methacrylate were further added to the mixture, and reacted for additional 3 hours. Thus, acryl copolymer 1 was obtained.

The weight average molecular weight of the acryl copolymer 1 was 35,000, measured according to GPC. The glass transition temperature Tg of the acryl copolymer 1 was 85° C, measured according to DSC (differential thermal analysis).

### (Preparation of support)

A 0.3 mm thick aluminum plate (material 1050, quality H16) was degreased at 60° C for one minute in a 5% sodium hydroxide solution, washed with water, immersed at 25° C for one minute in 10% hydrochloric acid solution to neutralize, and then washed with water.

The resulting aluminum plate was electrolytically etched using an alternating current at 25° C for 60 seconds at a current density of 100 A/dm² in a 0.3 weight % nitric acid solution, desmut at 60° C for 10 seconds in a 5 % sodium hydroxide solution.

The desmut aluminum plate was anodized at 25° C for 1 minute at a current density of 10 A/drn² and at a voltage of 15 V in a 15% sulfuric acid solution, and further subjected to hydrophilization at 75 °C in a 1% polyvinyl phosphonic acid solution. Thus, support was obtained.

The center line average surface roughness (Ra) of the support was 0.65 *µ*m.

### (Preparation of planographic printing plate material sample)

The following light sensitive layer coating solution 1 was coated on the resulting support through a wire bar, and dried at 95 °C for 1.5 minutes to give an image formation layer having a dry thickness of 1.5 g/m². Subsequently, the following oxygen shielding layer coating solution 1 was coated on the resulting light sensitive layer using a wire bar, and dried at 75° C for 1.5 minutes to give an oxygen shielding layer with a dry thickness of 1.5 g/m². Thus, inventive planographic printing plate material samples 1 through 4 and comparative planographic printing plate material sample 1 were prepared.

| (Light sensitive layer coating solution 1) | |
|---|---|
| Ethylenically unsaturated monomer 1 | 20.0 parts |
| Ethylenically unsaturated monomer 2 | 20.0 parts |
| Ethylenically unsaturated monomer 3 | 10.0 parts |
| Spectral sensitizing agent (as shown in Table 1) | amount shown in Table 1 |
| Polymerization initiator (as shown in Table 1) | amount shown in Table 1 |
| Chain transfer agent (as shown in Table 1) | amount shown in Table 1 |
| Acryl copolymer 1 | 40.0 parts |
| N-Phenylglycine benzyl ester | 4.0 parts |
| Phthalocyanine pigment (MHI 454 produced by Mikuni Sikisosha) | 3.5 parts |
| 2-t-Butyl-6-(3-t-butyl-2-hydroxy-5-methylbenzyl)-4-methylphenylacrylate (Sumirizer GS: produced by Sumitomo 3M Co., Ltd.) | 0.2 parts |
| 2,4,6-Tris(dimethylaminomethyl)phenol | 1.0 part |
| Bis(2,2,6,6-tetramethyl-4-piperidyl)sebacate | 0.1 parts |
| Fluorine-contained surfactant (F-178K: produced by Dainippon Ink Co., Ltd.) | 0.5 parts |
| Methyl ethyl ketone | 80 parts |
| Cyclohexanone | 820 parts |
| (Oxygen shielding layer coating solution 1) | |
| Polyvinyl alcohol (Gosenol AL-05, produced by Nippon Gosei Kagaku Co., Ltd.) | 85 parts |
| Polyvinyl pyrrolidone (Luvitek K-30, produced by BASF Inc.) | 15 parts |
| Surfinol 465 (produced by Air Products Inc.) | 0.2 parts |
| Water | 900 parts |

Ethylenically unsaturated monomer 1: Reaction product of n-butyl-diethanolamine (1 mole), tetramethylxylene diisocyanate (1 mole) and 1-methacryloyloxy-3-acryloyloxy-2-propanol (2 moles)
Ethylenically unsaturated monomer 2: Reaction product of hexane-1,6-diisocyanate (1 mole) and 2-hydroxypropylene-1,3-dimethacrylate (2 moles)
Ethylenically unsaturated monomer 3: Tetraethylene glycol dimethacrylate

### (Evaluation of planographic printing plate material samples)

### (Sensitivity)

Each of the planographic printing plate material samples obtained above was imagewise exposed at a resolving degree of 2400 dpi, employing a plate setter News (produced by ECRM Co., Ltd.) equipped with a 405 nm light source with an output power of 60 mW). Herein, dpi represents the dot numbers per 2.54 cm. The image pattern used for the exposure comprised a solid image and a square dot image with a screen number of 175 LPI and a 50% dot area.

Subsequently, the exposed sample was subjected to development treatment employing a CTP automatic developing machine (Raptor Polymer produced by Glunz & Jensen Inc.) to obtain a planographic printing plate. Herein, the developing machine comprised a preheating section set at 105 °C, a pre-washing section for removing the oxygen shielding layer before development, a development section set at 30 °C and charged with developer having the following developer composition, a washing section for removing the developer remaining on the developed sample after development, and a gumming section charged with a gumming solution (a solution obtained by diluting GW-3, produced by Mitsubishi Chemical Co., Ltd., with water by a factor of 2) for protecting the surface of the developed sample. Thus, planographic printing plate sample was obtained.

The minimum exposure energy (*µ*J/cm²), at which no thickness reduction of the solid image layer of the resulting printing plate obtained was observed, was defined as recording energy and evaluated as a measure of sensitivity. The less the recording energy is, the higher the sensitivity. The results are shown in Table 1.

### (Storage stability)

The printing plate material sample obtained above was stored at 55 °C for three days in a thermostat. Sensitivity of the resulting sample was determined in the same manner as above, and evaluated as a measure of storage stability. The results are shown in Table 1.

| Developer having the following composition (Aqueous solution containing the following components) | |
|---|---|
| Potassium silicate A (containing 25.5-27.5% by weight of SiO₂ and 12.5-14.5% by weight of K₂O) | 8.0 parts |
| Newcol B-13SN (produced by Nippon Nyukazai Co., Ltd.) | 3.0 parts |
| Water | 89.0 parts |
| Potassium hydroxide | amount giving pH 12.3 |

### (Developing property)

In a stainless steel vessel was placed 1 liter of the developer above. The printing plate material sample obtained above was cut in a sheet sample of a size of 20 cm x 25 cm (0.05 m²). Two hundred (total 10 m²) of the sheet sample were washed with hot water to remove the oxygen-shielding layer, and then immersed at 30 °C in the developer placed in the stainless steel vessel to dissolve the image formation layer. The developer was placed in a tightly sealed glass vessel, and stored at 40 °C for one week in a thermostat. Thereafter, the resulting developer was filtered under reduced pressure to obtain insoluble matter. The resulting insoluble matter was dried at 100 °C for 12 hours. An amount in terms of gram of the dried insoluble matter was measured and evaluated as a measure of developing property. The less the amount of the dried insoluble matter is, the better the developing property. The results are shown in Table 1.

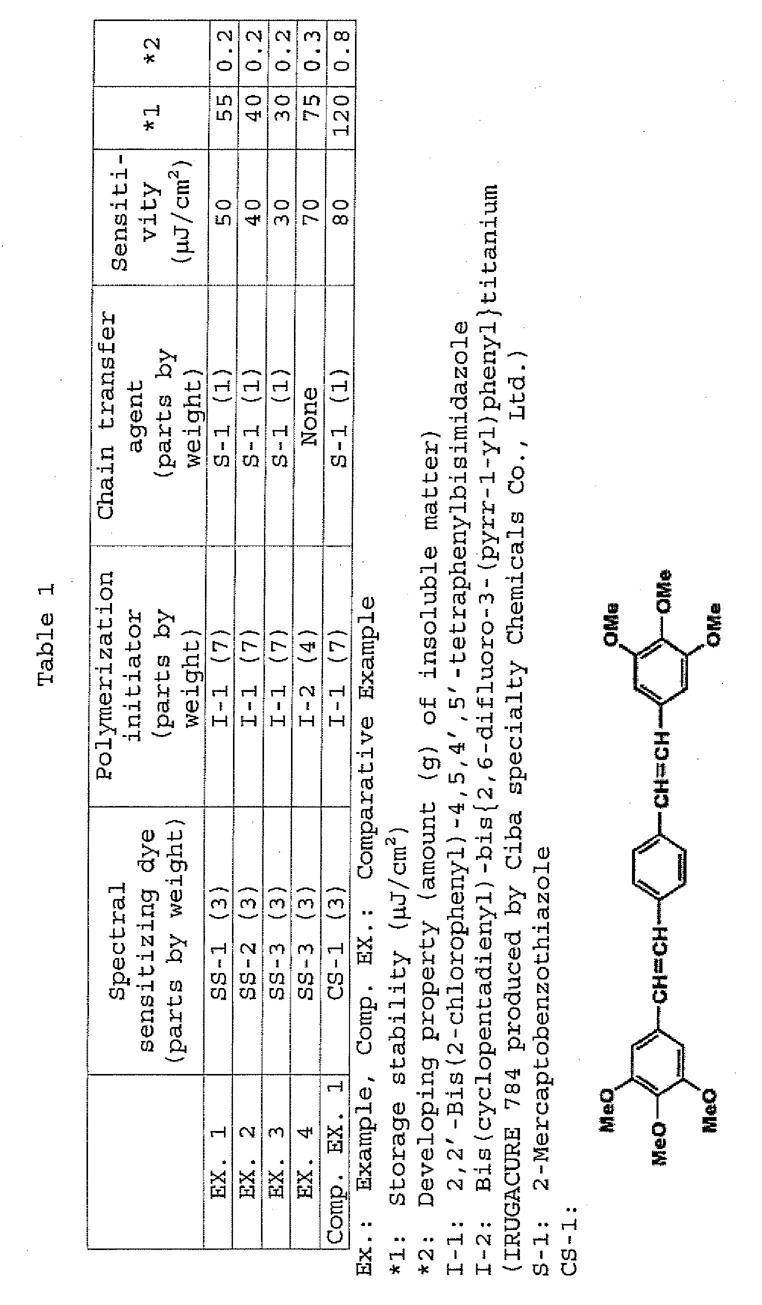

As is apparent from Table 1, inventive samples provide high sensitivity, excellent developing property, and particularly excellent storage stability.

## Claims

1. A light sensitive planographic printing plate material comprising a support and provided thereon, a light sensitive layer containing a spectral sensitizing agent, a photopolymerization initiator, a polymerizable compound, and a polymer binder, the light sensitive layer having a coating amount of from 0.1 to 10 g/m², wherein the spectral sensitizing agent is a compound represented by formula (1), 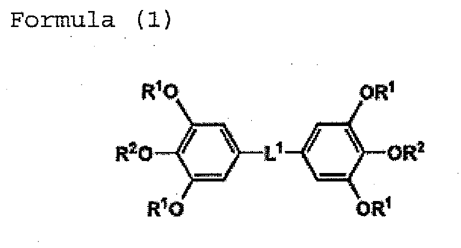 wherein R¹ represents a hydrogen atom, an alkyl group having a carbon atom number of from 1 to 6 or an aryl group; R² represents an alkyl group having a carbon atom number of from 2 to 30, an alkenyl group or an aryl group, R² being different from R¹; and L¹ represents a divalent linkage group selected from the group A consisting of linkage groups represented by the following formulae (a), (b), (c), (d), (e), (f), (g), (h), (i), (j), (k), (l), (m) and (n), 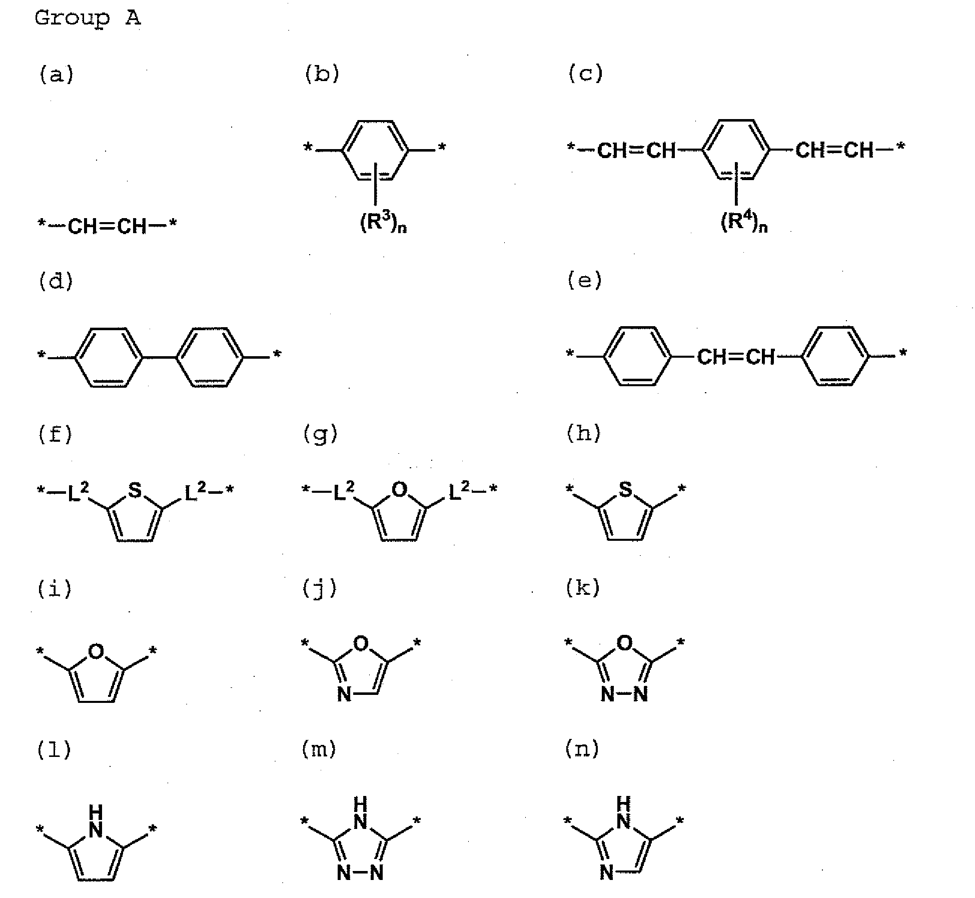 wherein R³ and R⁴ independently represent an alkyl group, an alkoxy group or a halogen atom; n represents an integer of from 0 to 4; the asterisk * represents a linkage position; and L² represents a divalent linkage group selected from the group B consisting of linkage groups represented by the following formulae (o), (p), (q), (r), (s), (t), (u), (v), and (w), 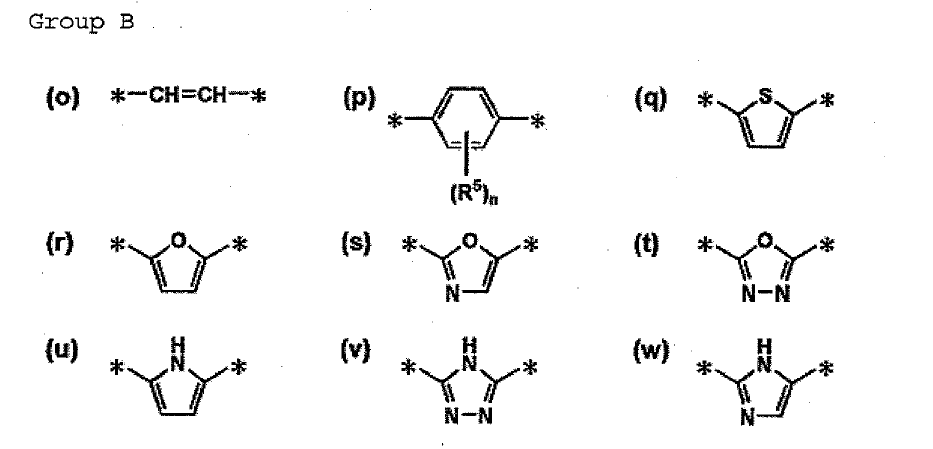 wherein R⁵ represents an alkyl group, an alkoxy group or a halogen atom; n represents an integer of from 0 to 4; and the asterisk "*" represents a linkage position.

2. The light sensitive planographic printing plate material of claim 1, wherein in formula (1), R² represents an alkyl group having a carbon atom number of from 2 to 6.

3. The light sensitive planographic printing plate material of claim 1 or 2, wherein in formula (1), R² represents an alkyl group having a carbon atom number of from 2 to 6; and L¹ represents a divalent linkage group represented by formula (c).

4. The light sensitive planographic printing plate material of any one of claims 1 through 3, wherein the polymerization initiator is a hexaarylbisimidazole compound.

5. The light sensitive planographic printing plate material of any one of claims 1 through 4, wherein the polymerizable compound is a compound having an ethylenically double bond.

6. The light sensitive planographic printing plate material of claim 1, wherein the light sensitive layer contains a mercapto compound.

7. The light sensitive planographic printing plate material of claim 1, wherein the light sensitive layer contains a polymerization inhibitor.

8. The light sensitive planographic printing plate material of claim 7, wherein the light sensitive layer contains the spectral sensitizing agent in an amount of from 0.1 to 20% by weight, the polymerization initiator in an amount of from 0.1 to 20% by weight, the polymerizable compound in an amount of from 10 to 70% by weight, the polymer binder in an amount of from 10 to 90% by weight, and the polymerization inhibitor in an amount of from 0.01 to 5% by weight.

9. The light sensitive planographic printing plate material of any one of claims 1 through 8, wherein a protective layer containing polyvinyl alcohol or polyvinyl pyrrolidone is provided on the light sensitive layer.

10. The light sensitive planographic printing plate material of any one of claims 1 through 9, wherein the light sensitive layer has a coating amount of from 0.5 to 5 g/m².
